(19) Europäisches Patentamt
European Patent Office
Office européen des brevets

(11) **EP 3 086 093 B1**

(12) **FASCICULE DE BREVET EUROPEEN**

(45) Date de publication et mention
de la délivrance du brevet:
**20.09.2017 Bulletin 2017/38**

(51) Int Cl.:
**G01D 4/00** *(2006.01)* **G01R 19/25** *(2006.01)*
**H02J 3/00** *(2006.01)*

(21) Numéro de dépôt: **16166742.3**

(22) Date de dépôt: **22.04.2016**

(54) **PROCÉDÉ ET SYSTÈME DE DÉTERMINATION DE LA STRUCTURE D'UN RÉSEAU DE DISTRIBUTION D'ÉLECTRICITÉ ET PROGRAMME D'ORDINATEUR ASSOCIÉ**

**VERFAHREN UND SYSTEM ZUR BESTIMMUNG DER STRUKTUR EINES STROMVERTEILUNGSNETZES, UND ENTSPRECHENDES COMPUTERPROGRAMM**

**METHOD AND SYSTEM FOR DETERMINING THE STRUCTURE OF AN ELECTRICITY DISTRIBUTION NETWORK AND RELATED COMPUTER PROGRAM**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.04.2015 FR 1553646**

(43) Date de publication de la demande:
**26.10.2016 Bulletin 2016/43**

(73) Titulaire: **Schneider Electric Industries SAS**
**92500 Rueil-Malmaison (FR)**

(72) Inventeurs:
• **GOUIN, Victor**
 **38050 GRENOBLE (FR)**
• **ALVAREZ-HERAULT, Marie-Cécile**
 **38050 GRENOBLE (FR)**
• **DESCHAMPS, Philippe**
 **38050 GRENOBLE (FR)**
• **MARIÉ, Sylvain**
 **38050 GRENOBLE (FR)**
• **LAMOUDI, Yacine**
 **38050 GRENOBLE (FR)**

(74) Mandataire: **Lavoix**
**2, place d'Estienne d'Orves**
**75441 Paris Cedex 09 (FR)**

(56) Documents cités:
**EP-A2- 2 458 340 WO-A1-2009/061291**
**WO-A1-2012/113936 US-A1- 2011 184 576**

**Description**

La présente invention concerne un procédé mis en oeuvre par ordinateur, de détermination de la structure d'un réseau de distribution d'électricité, un programme d'ordinateur associé et un système de détermination de la structure du réseau de distribution d'électricité.

Dans le domaine de la distribution d'électricité, il est connu d'assurer la distribution d'électricité à une pluralité de consommateurs électriques via un réseau de distribution d'électricité comprenant un poste de transformation électrique, le poste comportant des départs électriques d'alimentation en énergie électrique des consommateurs électriques. Le poste de transformation est, par exemple, un poste de transformation haute tension/moyenne tension (HTB/HTA) ou moyenne tension/basse tension (HTA/BT) et les départs électriques sont des départs en moyenne ou en basse tension.

La haute tension, correspond à une tension supérieure à 50 kVolts (kV), la moyenne tension correspond à une tension comprise entre 1 kV et 50 kV et la basse tension correspond à une tension inférieure à 1 kV.

Dans de tels réseaux de distribution électrique, les consommateurs sont alimentés soit en triphasé, soit en monophasé, et le poste de transformation est configuré pour répartir la puissance électrique qu'il reçoit entre les différents départs électriques.

Cependant, la structure, et plus précisément la cartographie, des réseaux de distribution d'électricité alimentant les consommateurs électriques est généralement mal connue. Or, la connaissance de la structure de tels réseaux est devenue essentielle pour répondre aux contraintes que les régulateurs nationaux imposent aux distributeurs d'électricité, notamment en termes de qualité de fourniture d'électricité.

En effet, les régulateurs nationaux imposent aux distributeurs d'électricité des objectifs de qualité de service, et ceux-ci doivent être mesurables. Les distributeurs d'électricité ont donc dorénavant besoin de mieux connaître la structure des réseaux de distribution d'électricité, notamment pour localiser les éventuels défauts ou défaillances sur le réseau ou encore pour identifier les départs du poste de transformation les plus contributeurs en termes de pertes électriques.

Il est ainsi connu de EP 2 458 340 A2 un procédé permettant de déterminer la structure d'un réseau de distribution d'électricité à partir de moyens de calcul spécifiques et d'informations relatives à l'énergie électrique consommée par chaque consommateur électrique relié au réseau et relatives à l'énergie électrique délivrée par chaque départ du poste de transformation. US 2011/0184567 A1, WO 2009/061291 A1 et WO 2012/113936 A1 divulguent différentes méthodes de détermination de la hiérarchie et de la connectivité d'un réseau de distribution d'électricité. Cependant, la rapidité d'exécution, la précision et la fiabilité d'un tel procédé restent à améliorer.

Le but de l'invention est donc de proposer un procédé de détermination robuste de la structure d'un réseau de distribution d'électricité permettant de déterminer la structure du réseau de distribution d'électricité de manière plus sûre, plus fiable et plus rapide. Un tel procédé permet notamment de s'affranchir d'erreurs, par exemple liées à des imprécisions de mesure de l'énergie consommée et/ou délivrée ou à l'absence de certaines mesures d'énergie.

A cet effet, l'invention a pour objet un procédé de détermination de la structure d'un réseau de distribution d'électricité le procédé étant mis en oeuvre par ordinateur, le réseau de distribution comprenant un poste d'alimentation comportant un ou plusieurs départs d'alimentation en énergie électrique de plusieurs consommateurs électriques et comprenant les étapes suivantes :

- a) l'acquisition, pour chaque consommateur électrique, de premières données relatives à l'énergie électrique consommée par le consommateur électrique pendant différents intervalles temporels, mesurées via un premier capteur de mesure d'énergie,
- b) l'acquisition, pour chaque départ, de deuxièmes données relatives à l'énergie électrique délivrée par le départ pendant les différents intervalles temporels, mesurées via un deuxième capteur de mesure d'énergie,
- c) la génération, via un module de génération, de plusieurs jeux de données différents, associés chacun à l'un des intervalles temporels, chaque jeu de données comprenant les premières et deuxièmes données associées audit intervalle temporel,

caractérisé en ce que le procédé comprend en outre les étapes suivantes :

- d) le calcul d'un premier critère de sélection pour chaque jeu de données, le premier critère de sélection étant un critère choisi parmi un taux global de pertes d'énergie électrique entre le ou les départs et les consommateurs et un écart de consommation d'énergie électrique entre les différents consommateurs,
- e) la sélection, par une unité de sélection et en fonction des premiers critères de sélection calculés, d'un premier ensemble de jeux de données parmi les jeux générés,
- f) la détermination, à partir du premier ensemble sélectionné, de paramètres de raccordement, lesdits paramètres comportant pour chaque consommateur électrique un identifiant du départ auquel il est raccordé..

Grâce à l'invention, les étapes de sélection du premier ensemble de jeux de données en fonction des premiers critères de sélection calculés et de détermination des paramètres de raccordement à partir du premier ensemble sélectionné permettent de déterminer de manière plus fiable et plus rapide la structure du réseau de distribution d'électricité.

Selon d'autres aspects avantageux de l'invention, le procédé de détermination comprend en outre une ou plusieurs des caractéristiques suivantes, prises isolément ou selon toutes les combinaisons techniquement admissibles :

- lors de l'étape de calcul d), un deuxième critère de sélection pour chaque jeu de données généré est calculé, le deuxième critère étant l'autre critère choisi parmi un taux global de pertes d'énergie électrique entre le ou les départs et les consommateurs et un écart de consommation d'énergie électrique entre les différents consommateurs,

et, lors de l'étape de sélection e), le premier ensemble est sélectionné en fonction des premiers et deuxièmes critères calculés ;

- suite à l'étape de sélection e), le procédé comprend les étapes suivantes :

  - e1) le calcul d'un deuxième critère de sélection pour chaque jeu de données du premier ensemble, le deuxième critère étant l'autre critère choisi parmi un taux global de pertes d'énergie électrique entre le ou les départs et les consommateurs et un écart de consommation d'énergie électrique entre les différents consommateurs,
  - e2) la sélection en fonction des deuxièmes critères de sélection calculés

d'un deuxième ensemble de jeux de données parmi le premier ensemble, la détermination des paramètres de raccordement étant alors effectuée lors de l'étape de détermination f) en fonction du deuxième ensemble sélectionné parmi le premier ensemble ;

- lors de l'étape de détermination f), les paramètres de raccordement sont déterminés séparément pour chaque départ et indépendamment des deuxièmes données relatives à l'énergie électrique acquises pour les autres départs ;
- lors de l'étape de détermination f), un système d'équation à résoudre est déterminé à partir d'un postulat de conservation de l'énergie électrique pour chaque départ selon lequel l'énergie délivrée par le départ est sensiblement égale à la somme de l'énergie consommée par les consommateurs électriques connectés au départ et des pertes électriques ;
- lors de l'étape de détermination f), le système d'équation est défini à partir de l'équation suivante :

$$E_{Dj}(t_k) = \sum_{i=1}^{n} (a_{ij}.E_{Ci}(t_k) + \partial 1_{jk} - \partial 2_{jk}) \, ,$$

où n est le nombre de consommateurs électriques, j est un indice de départ variant de 1 à m, m étant le nombre de départs, i est un indice de consommateur électrique variant de 1 à n,
k est un indice de jeu de données du premier ensemble variant de 1 à w, w étant le nombre de jeux de données du premier ensemble, $t_k$ est l'intervalle temporel associé au jeu de données d'indice k,
$a_{ij}$ est le paramètre de raccordement indiquant si le consommateur d'indice i est raccordé au départ d'indice j,
$E_{Ci}(t_k)$ est l'énergie électrique consommée par le consommateur électrique d'indice i pendant l'intervalle temporel $t_k$,
$E_{Dj}(t_k)$ est l'énergie électrique délivrée par le départ d'indice j pendant l'intervalle temporel $t_k$, et
$\partial 1_{jk}$ et $\partial 2_{jk}$ sont des variables d'ajustement représentatives des pertes électriques ;

- le système d'équation s'écrit sous une forme matricielle de la manière suivante :

$$A*z = B,$$

où $z = \begin{bmatrix} a_{11} \\ \vdots \\ a_{n1} \\ \vdots \\ a_{1m} \\ \vdots \\ a_{nm} \\ \partial 1_{11} \\ \vdots \\ \partial 1_{mw} \\ \partial 2_{11} \\ \vdots \\ \partial 2_{mw} \end{bmatrix}$ , $B = \begin{bmatrix} E_{D1}(t_1) \\ \vdots \\ E_{D1}(t_w) \\ E_{D2}(t_1) \\ \vdots \\ E_{D2}(t_w) \\ E_{Dm}(t_1) \\ \vdots \\ E_{Dm}(t_k) \end{bmatrix}$ et $A = \begin{bmatrix} U & 0 & \cdots & 0 \\ 0 & \ddots & \ddots & \vdots \\ \vdots & \ddots & \ddots & 0 \\ 0 & \cdots & 0 & U \end{bmatrix}$ avec

$U = \begin{bmatrix} E_{C1}(t_1) & \cdots & E_{Cn}(t_1) \\ \vdots & \ddots & \vdots \\ E_{C1}(t_w) & \cdots & E_{Cn}(t_w) \end{bmatrix}$ et A comprenant m*n colonnes et m*w lignes ;

- lors l'étape de détermination, un algorithme d'optimisation est utilisé pour résoudre le système d'équation, l'algorithme d'optimisation vérifiant :

$$\min_z f^T.z \quad \text{tel que} \quad \begin{cases} A.z = B \\ l_z \le z \le u_z \end{cases},$$

où

$$f^T.z = \underbrace{\begin{bmatrix} 0 & \cdots & 0 \end{bmatrix}}_{m*n} \; \underbrace{\begin{matrix} 1 & \cdots & 1 \end{matrix}}_{w*m} \; \underbrace{\begin{matrix} 1 & \cdots & 1 \end{matrix}}_{w*m} \times z ,$$

$$l_z = \begin{bmatrix} -\varepsilon \\ \vdots \\ -\varepsilon \\ 0 \\ \vdots \\ 0 \end{bmatrix} \text{ et } u_z = \begin{bmatrix} 1+\varepsilon \\ \vdots \\ 1+\varepsilon \\ +\infty \\ \vdots \\ +\infty \end{bmatrix} ,$$

avec $\varepsilon$ compris entre 0 et 0,5 ;
- chaque départ comprend un ou plusieurs conducteurs électriques de phase, et, lors de l'étape d'acquisition b), les deuxièmes données sont acquises pour chaque conducteur électrique de phase et sont relatives à l'énergie électrique délivrée par chaque conducteur électrique de phase, et, lors de l'étape de détermination f), les paramètres de raccordement déterminés comportent pour chaque consommateur électrique un identifiant du ou des conducteurs électriques de phase auxquels il est raccordé ;

- lors de l'étape de détermination f), le procédé comprend les étapes suivantes :

  - f1) la sélection pseudo-aléatoire d'un troisième ensemble de jeux de données inclus dans le premier ensemble,
  - f2) la détermination des paramètres de raccordement à partir du troisième ensemble sélectionné parmi le premier ensemble ;

- suite à l'étape f1) de sélection et précédemment à l'étape de détermination f2), le procédé comprend les étapes suivantes :

  - f3) le calcul d'un paramètre de répétition,
  - f4) la détermination, à partir du troisième ensemble sélectionné, d'indices intermédiaires de raccordement comportant pour chaque consommateur électrique un identifiant du départ auquel il est raccordé,
  - f5) la mémorisation des indices intermédiaires de raccordement, et
  - f6) la comparaison du paramètre de répétition avec au moins un critère de répétition prédéterminés,

  et, suivant le résultat de l'étape de comparaison f6), la réalisation d'une étape parmi, d'une part, la répétition des étapes de sélection f1), de calcul f3), de détermination f4), de mémorisation f5) et de comparaison f6) et, d'autre part, l'étape de détermination f2) des paramètres de raccordement en fonction des indices intermédiaires de raccordement mémorisés ;

- le procédé comprend l'étape suivante :

  - f7) le calcul, pour chaque consommateur et pour chaque départ, d'un nombre d'affectation relatif au nombre de fois où les indices intermédiaires de raccordement mémorisés indiquent que le consommateur est raccordé au départ,

  et, lors de l'étape de détermination f2), les paramètres de raccordement sont déterminés à partir des nombres d'affectation calculés.

L'invention a également pour objet un programme d'ordinateur comportant des instructions logicielles, qui lorsqu'elles sont exécutées par un ordinateur mettent en oeuvre le procédé défini ci-dessus.

L'invention a, en outre, pour objet un système de détermination de la structure d'un réseau de distribution d'électricité, le réseau de distribution comprenant un poste d'alimentation comportant un ou plusieurs départs d'alimentation en énergie électrique de plusieurs consommateurs électriques, le système comprenant :

- pour chaque consommateur électrique, un premier capteur de mesure de premières données relatives à l'énergie électrique consommée par le consommateur pendant différents intervalles temporels,
- pour chaque départ, un deuxième capteur de mesure de deuxièmes données relatives à l'énergie électrique délivrée par le départ pendant les différents intervalles temporels,
- un module d'acquisition des premières et deuxièmes données,
- un module de génération de plusieurs jeux de données différents, associés chacun à l'un des intervalles temporels, chaque jeux de données comprenant les premières et deuxièmes données associées audit intervalle temporel,

caractérisé en ce que le système de détermination comprend en outre :

- un module de calcul d'un premier critère de sélection pour chaque jeu de données, le premier critère de sélection étant un critère choisi parmi un taux global de pertes d'énergie électrique entre le ou les départs et les consommateurs et un écart de consommation d'énergie électrique entre les différents consommateurs,
- un module de sélection, en fonction des premiers critères de sélection calculés, d'un premier ensemble de jeux de données parmi les jeux générés, et
- un module détermination, à partir du premier ensemble sélectionné, de paramètres de raccordement, lesdits paramètres comportant pour chaque consommateur électrique un identifiant du départ auquel il est raccordé.

L'invention sera mieux comprise et d'autres avantages de celle-ci apparaitront plus clairement à la lumière de la description qui va suivre, donnée uniquement à titre d'exemple non limitatif, et faite en se référant aux dessins sur lesquels :

- la figure 1 est une représentation schématique d'un réseau de distribution d'électricité comprenant un poste d'alimentation comportant plusieurs départs d'alimentation en énergie électrique de plusieurs consommateurs électriques ;

- la figure 2 est un organigramme d'un procédé de détermination de la structure du réseau de distribution d'électricité de la figure 1, selon un premier mode de réalisation de l'invention ;
- la figure 3 est un organigramme analogue à celui de la figure 2, selon un deuxième mode de réalisation de l'invention ;
- la figure 4 est un organigramme analogue à celui de la figure 2, selon un troisième mode de réalisation de l'invention ; et
- la figure 5 est un organigramme analogue à celui de la figure 2, selon un quatrième mode de réalisation de l'invention.

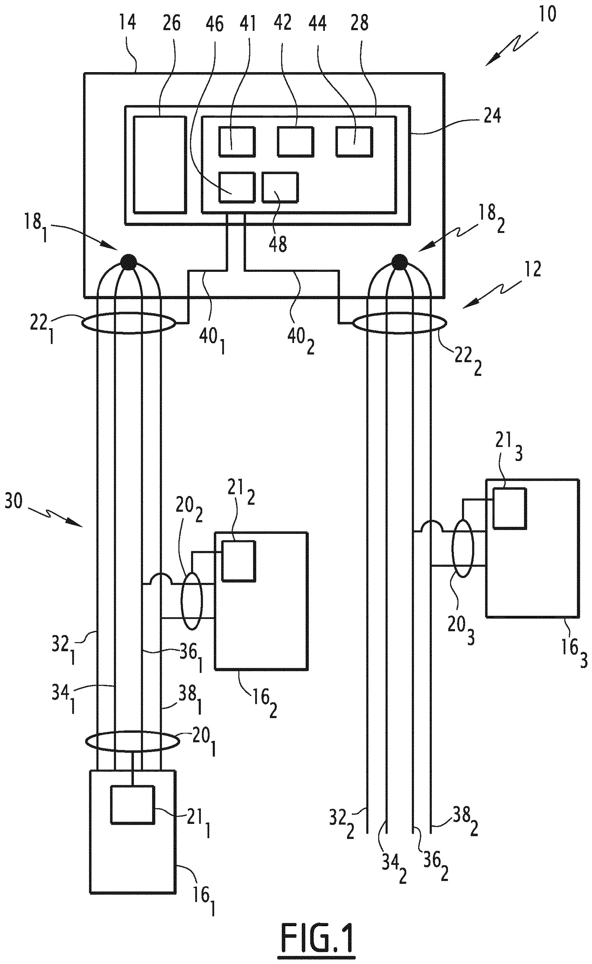

Sur la figure 1, un réseau 10 de distribution d'électricité est associé à un système 12 de détermination de la structure du réseau de distribution d'électricité 10. Le réseau de distribution 10 comprend un poste d'alimentation 14 en énergie électrique de plusieurs consommateurs électriques $16_i$. Le poste d'alimentation 14 comporte des départs électriques $18_j$ d'alimentation en énergie électrique des consommateurs électriques $16_i$, avec i un indice de consommateur électrique et j un indice de départ.

L'indice i de consommateur électrique varie de 1 à n, où n est le nombre de consommateurs électriques $16_i$ et l'indice de départ j varie de 1 à m, où m est le nombre de départs électriques $18_j$. Dans l'exemple de la figure 1, le nombre n de consommateurs électriques $16_i$ est égal à 3, et le nombre m de départs électriques $18_j$ est égal à 2.

Le système de détermination 12 comprend, pour chaque consommateur électrique $16_i$, un premier capteur $20_i$ de mesure d'énergie et un module $21_i$ de transmission des mesures d'énergie réalisées par le premier capteur $20_i$ correspondant.

Le système de détermination 12 comporte, pour chaque départ $18_j$, un deuxième capteur $22_j$ de mesure d'énergie.

Le système de détermination 12 comprend également une unité de traitement d'informations 24 formée par exemple d'un processeur 26 et d'une mémoire 28 associée au processeur 26.

Le poste d'alimentation 14 est, par exemple, un poste de transformation moyenne tension/basse tension relié entre un réseau moyenne tension, non représenté, et un réseau basse tension 30 correspondant aux consommateurs électriques $16_i$.

Le poste d'alimentation 14 inclut, au niveau de chaque départ $18_j$, le deuxième capteur $22_j$ correspondant.

Les consommateurs électriques $16_i$ sont raccordés au poste d'alimentation 14 via les départs $18_j$. Plus précisément, dans l'exemple de la figure 1, les consommateurs électriques $16_1$, $16_2$ sont reliés au départ $18_1$ et le consommateur électrique $16_3$ est relié au départ $18_2$.

Les consommateurs électriques $16_i$ sont soit triphasés et alimentés par le départ $18_j$ correspondant via quatre conducteurs électriques $32_j$, $34_j$, $36_j$, $38_j$, c'est-à-dire trois conducteurs électriques de phase $32_j$, $34_j$, $36_j$ et un conducteur électrique de neutre $38_j$, soit monophasés et alimentés par le départ $18_j$ correspondant via deux conducteurs électriques :c'est-à-dire, par exemple un conducteur de phase $32_j$ , $34_j$ ou $36_j$ et le conducteur de neutre $38_j$.

Dans l'exemple de la figure 1, le consommateur électrique $16_1$ est triphasé et les consommateurs électriques $16_2$, $16_3$ sont monophasés.

Chaque consommateur électrique $16_i$ inclut l'un des premiers capteurs $20_i$ correspondant et l'un des modules de transmission $21_i$ correspondant.

Chaque consommateur électrique $16_i$ est, par exemple, un compteur de consommation électrique communiquant, propre à mesurer des premières données $E_{Ci}$ relatives à l'énergie électrique consommée par le consommateur électrique $16_i$, via le premier capteur $20_i$ correspondant, et à transmettre les premières données $E_{Ci}$ à l'unité de traitement 24 via le module de transmission $21_i$ correspondant.

Chaque départ $18_j$ est un départ triphasé et comprend les trois conducteurs de phase $32_j$, $34_j$, $36_j$ correspondants et le conducteur de neutre $38_j$ correspondant. En variante, non représentée, les départs électriques sont monophasés et comprennent un conducteur de phase et un conducteur de neutre. Selon encore une autre variante, non représentée, certains départs sont monophasés et d'autres sont triphasés.

Chaque premier capteur $20_i$ est propre à mesurer les premières données $E_{Ci}(t_l)$ relatives à l'énergie électrique consommée par le consommateur électrique $16_i$ correspondant, pendant différents intervalles temporels $t_l$.

Plus généralement, les premiers capteurs $20_i$ sont configurés pour mesurer les premières données $E_{Ci}(t_l)$ pendant les mêmes intervalles temporels $t_l$, les premières données $E_{Ci}(t_l)$ mesurées au niveau de chaque consommateur électrique $16_i$ étant mesurés de manière synchrone.

Chaque module de transmission $21_i$ est propre à transmettre les premières données $E_{Ci}(t_l)$ mesurées par le premier capteur $20_i$ correspondant à destination de l'unité de traitement 24.

Avantageusement, chaque module de transmission $21_i$ est propre à transmettre avec les premières données $E_{Ci}(t_l)$ une première information relative à l'intervalle temporel pendant lequel les premières données ont été mesurées.

Chaque deuxième capteur $22_j$ est propre à mesurer des deuxièmes données $E_{Dj}(t_l)$ relatives à l'énergie électrique délivrée par le départ $18_j$ correspondant pendant les différents intervalles temporels $t_l$.

Les premières $E_{Ci}(t_l)$ et deuxièmes $E_{Dj}(t_l)$ données mesurées sont alors synchronisées au sens où elles sont mesurées pendant des intervalles temporels $t_l$ identiques.

Chaque deuxième capteur $22_j$ est également configuré pour transmettre, via une liaison électrique respective $40_j$, les deuxièmes données $E_{Dj}(t_l)$ qu'il mesure à l'unité de traitement 24.

Avantageusement, chaque deuxième capteur $22_j$ est configuré pour transmettre avec les deuxièmes données $E_{Dj}(t_l)$ une deuxième information relative à l'intervalle temporel $t_l$ pendant lequel les deuxièmes données $E_{Dj}(t_l)$ ont été mesurées.

Les premières $E_{Ci}(t_l)$ et deuxièmes $E_{Dj}(t_l)$ données sont, par exemple, des mesures d'énergie active.

Plus précisément, dans la suite de la description, on considère que les premières $E_{Ci}(t_l)$ et deuxièmes $E_{Dj}(t_l)$ données sont des mesures d'énergie active.

En variante, les premières $E_{Ci}(t_l)$ et deuxièmes $E_{Dj}(t_l)$ données sont des mesures d'énergie réactive, des mesures d'énergie apparente, des mesures de puissance active, des mesures de puissance réactive, des mesures de puissance apparente ou encore des mesures d'intensité.

Le processeur 26 est configuré pour exécuter des logiciels compris dans la mémoire 28.

La mémoire 28 comprend un logiciel 41 d'acquisition des premières $E_{Ci}(t_l)$ et deuxièmes $E_{Dj}(t_l)$ données, un logiciel 42 de génération de plusieurs jeux de données différents $Je_l$ à partir des premières données $E_{Ci}(t_l)$ et des deuxièmes données $E_{Dj}(t_l)$ acquises dans un même intervalle temporel $t_l$ et un logiciel 44 de calcul d'un premier critère de sélection $C1_l$ pour chaque jeu de données $Je_l$.

La mémoire 28 comprend également un logiciel 46 de sélection d'un premier ensemble $En_1$ de jeux de données $Je_l$, en fonction des premiers critères de sélection $C1_l$ calculés par le logiciel de calcul 44 et un logiciel 48 de détermination de paramètres de raccordement $a_{ij}$, lesdits paramètres de raccordement comportant pour chaque consommateur électrique $16_i$ un identifiant du départ $18_j$ auquel il est raccordé.

Les logiciels d'acquisition 41, de génération 42, de calcul 44, de sélection 46 et de détermination 48 correspondent à des instructions logicielles et forment un programme d'ordinateur apte à être exécuté par un ordinateur. L'ordinateur correspond, par exemple, à l'unité de traitement 24.

Le logiciel d'acquisition 41 est propre, par exemple, à transmettre à chaque consommateur électrique $16_i$ et notamment à chaque premier capteur $20_i$ un ordre de mesure des premières données $E_{Ci}(t_l)$ et un ordre de transmission des premières données $E_{Ci}(t_l)$, afin de récupérer les premières données.

De même, le logiciel d'acquisition 41 est, par exemple, configuré pour transmettre à chaque départ $18_j$ et notamment à chaque deuxième capteur $22_j$ un ordre de mesure des deuxièmes données $E_{Dj}(t_l)$ et un ordre de transmission des deuxièmes données $E_{Dj}(t_l)$, afin de récupérer les deuxièmes données $E_{Dj}(t_l)$.

Avantageusement les ordres de mesure des premières $E_{Ci}(t_l)$ et deuxièmes $E_{Dj}(t_l)$ données sont transmis simultanément à tous les départs $18_j$ et tous les consommateurs $16_i$.

Le logiciel de génération 42 est configuré pour générer les jeux de données $Je_l$ qui sont chacun associés à l'un des intervalles temporel $t_l$ et qui comprennent les premières $E_{Ci}(t_l)$ et deuxièmes $E_{Dj}(t_l)$ données associées audit intervalle temporel $t_l$. En d'autres termes, le logiciel de génération 42 sélectionne les premières $E_{Ci}(t_l)$ et deuxièmes $E_{Dj}(t_l)$ données mesurées pendant les différents intervalles temporels $t_l$, pour créer les jeux de données $Je_l$.

Le logiciel de calcul 44 est adapté pour calculer, pour chaque jeu de données $Je_l$, le premier critère de sélection $C1_l$, qui est choisi parmi un taux global de pertes d'énergie électrique entre les départs $18_j$ et les consommateurs électriques $16_i$ et un écart de consommation d'énergie électrique entre les différents consommateurs $16_i$. Les pertes d'énergie électrique, incluent aussi bien les pertes dites techniques, par exemple liées aux pertes Joule lors de la circulation du courant entre les départs 18j et les consommateurs 16i, que les pertes dites non techniques, qui sont par exemple liées au vol d'électricité, au fait que des consommateurs sont raccordés au réseau de distribution 10 sans que l'unité de traitement d'informations 24 en soit informée et à des premiers capteurs $20_i$ défectueux.

Si le premier critère de sélection $C1_l$ est, par exemple, le taux global de pertes d'énergie électrique entre les départs $18_j$ et les consommateurs $16_i$, le premier critère de sélection $C1_l$ est calculé à partir de la formule suivante :

$$C1_l = \frac{\Delta E}{E}(t_l) = \frac{\sum_{j=1}^{m} E_{Dj}(t_l) - \sum_{i=1}^{n} E_{Ci}(t_l)}{\sum_{j=1}^{m} E_{Dj}(t_l)}, \tag{1}$$

où l est un indice de jeu de données et varie de 1 à r, r étant le nombre de jeux données générés par le logiciel de génération 42, $t_l$ est l'intervalle temporel associé au jeu de données d'indice l, $E_{Ci}(t_l)$ est l'énergie électrique consommée par le consommateur électrique d'indice i pendant l'intervalle temporel $t_l$ et $E_{Dj}(t_l)$ est l'énergie électrique délivrée par le départ d'indice j pendant l'intervalle temporel $t_l$.

Si le premier critère de sélection $C1_l$ est, par exemple, l'écart de consommation d'énergie électrique entre les

différents consommateurs $16_i$, le premier critère de sélection $C1_l$ est calculé à partir de la formule suivante :

$$C1_l = Var(E_{C1}(tk), \cdots, E_{Cn}(tk)), \qquad (2)$$

où Var est la fonction variance.

En variante, si le premier critère de sélection $C1_l$ est, par exemple, l'écart relatif de consommation d'énergie électrique entre les différents consommateurs, le premier critère de sélection $C1_l$ est calculé à partir de la formule suivante :

$$C1_l = \frac{Var(E_{C1}(tk), \cdots, E_{Cn}(tk))}{Moy(E_{C1}(tk), \cdots, E_{Cn}(tk))}, \qquad (3)$$

où Moy est une fonction moyenne, telle qu'une moyenne arithmétique, géométrique, quadratique...

Le logiciel de sélection 46 est configuré pour sélectionner le premier ensemble $En_1$ de jeux de données parmi les jeux de données $Je_l$ générés par le logiciel de génération 42, en fonction des premiers critères de sélection $C1_l$ calculés. Le logiciel de sélection 46 est, par exemple, configuré pour comparer les premiers critères $C1_l$ avec une première variable prédéterminée V1 et pour sélectionner les jeux de données $Je_l$ pour lesquels le premier critère $C1_l$ est inférieur à la première variable prédéterminée V1.

Le logiciel de détermination 48 est configuré pour déterminer les paramètres de raccordement $a_{ij}$ à partir du premier ensemble $En_1$ sélectionné.

Le logiciel de détermination 48 est, par exemple, configuré pour établir ou déterminer un système d'équation à résoudre à partir d'un postulat de conservation de l'énergie électrique pour chaque départ $18_j$, selon lequel l'énergie délivrée par le départ $18_j$ est sensiblement égale à la somme de l'énergie consommée par les consommateurs électriques $16_i$ connectés au départ $18_j$ et des pertes électriques.

Le système d'équation est, par exemple, défini à partir de l'équation suivante :

$$E_{Dj}(t_k) = \sum_{i=1}^{n} (a_{ij}.E_{Ci}(t_k) + \partial 1_{jk} - \partial 2_{jk}) \qquad (4)$$

où n est le nombre de consommateurs électriques, j est un indice de départ variant de 1 à m, m étant le nombre de départs, i est un indice de consommateur électrique variant de 1 à n,

k est un indice de jeu de données $Je_k$ du premier ensemble $En_1$ variant de 1 à w, w étant le nombre de jeux de données $Je_k$ du premier ensemble $En_1$, $t_k$ est l'intervalle temporel associé au jeu de données $Je_k$ d'indice k,

$a_{ij}$ est le paramètre de raccordement indiquant si le consommateur d'indice i est raccordé au départ d'indice j,

$E_{Ci}(t_k)$ est l'énergie électrique consommée par le consommateur électrique d'indice i pendant l'intervalle temporel $t_k$,

$E_{Dj}(t_k)$ est l'énergie électrique délivrée par le départ d'indice j pendant l'intervalle temporel $t_k$, et

$\partial 1_{jk}$ et $\partial 2_{jk}$ sont des variables d'ajustement représentatives des pertes électriques, c'est à dire de l'écart pour chaque jeu de donnée $Je_k$ et pour chaque départ $18_j$ entre l'énergie électrique délivrée par le départ $18_j$ et l'énergie électrique consommée par les consommateurs électriques $16_i$ raccordés au départ d'indice j.

Le système d'équation s'écrit alors par exemple sous une forme matricielle de la manière suivante :

$$A^*z = B, \qquad (5)$$

$$\text{où } z = \begin{bmatrix} a_{11} \\ \vdots \\ a_{n1} \\ \vdots \\ a_{1m} \\ \vdots \\ a_{nm} \\ \partial 1_{11} \\ \vdots \\ \partial 1_{mw} \\ \partial 2_{11} \\ \vdots \\ \partial 2_{mw} \end{bmatrix}, \ B = \begin{bmatrix} E_{D1}(t_1) \\ \vdots \\ E_{D1}(t_w) \\ E_{D2}(t_1) \\ \vdots \\ E_{D2}(t_w) \\ E_{Dm}(t_1) \\ \vdots \\ E_{Dm}(t_k) \end{bmatrix}$$

et $A = [D \ I_{w*m} \ -I_{w*m}]$, $I_{w*m}$ représentante la matrice unité de taille w*m, avec

$$D = \begin{bmatrix} U & 0 & \cdots & 0 \\ 0 & \ddots & \ddots & \vdots \\ \vdots & \ddots & \ddots & 0 \\ 0 & \cdots & 0 & U \end{bmatrix}, \ U = \begin{bmatrix} E_{C1}(t_1) & \cdots & E_{Cn}(t_1) \\ \vdots & \ddots & \vdots \\ E_{C1}(t_w) & \cdots & E_{Cn}(t_w) \end{bmatrix}$$

et D comprenant m*n colonnes et m*w lignes.

Le logiciel de détermination 48 est alors configuré pour résoudre le système d'équation à partir d'un algorithme d'optimisation vérifiant :

$$\min_z f^T.z \quad \text{tel que} \ \begin{cases} A.z = B \\ l_z \le z \le u_z \end{cases}, \tag{6}$$

où $f^T.z = \begin{bmatrix} \underbrace{0 \ \cdots \ 0}_{m*n} & \underbrace{1 \ \cdots \ 1}_{w*m} & \underbrace{1 \ \cdots \ 1}_{w*m} \end{bmatrix} \times z$, $f^T$ correspondant à une fonction coût de l'algorithme d'optimisation et z à un vecteur objectif défini ci-dessus et où, $l_z = \begin{bmatrix} -\varepsilon \\ \vdots \\ -\varepsilon \\ 0 \\ \vdots \\ 0 \end{bmatrix}$, $l_z$ étant de dimension m*n+2*w*m et comprenant m*n fois la valeur -ε et 2*w*m fois la valeur 0 et $u_z = \begin{bmatrix} 1+\varepsilon \\ \vdots \\ 1+\varepsilon \\ +\infty \\ \vdots \\ +\infty \end{bmatrix}$, $u_z$ étant de dimension m*n+2*w*m et comprenant m*n fois la valeur (1+ε) et 2*w*m fois la valeur +∞, avec $\varepsilon$ compris entre 0 et 0,5, de préférence compris entre 0 et 0,1, de préférence encore égal à 0,05.

L'algorithme d'optimisation est propre à déterminer le vecteur objectif $z$ et donc les paramètres de raccordement pour lesquels la fonction $f^T.z$ est minimisée. Plus précisément, le logiciel de détermination 48 est configuré pour démarrer à partir d'un vecteur solution $X = \begin{bmatrix} a_{11} \\ \vdots \\ a_{nm} \end{bmatrix}$ initial choisi aléatoirement et pour converger de façon itérative vers une solution. A chaque itération, les variables d'ajustement $\partial 1_{jk}$, $\partial 2_{jk}$ et la fonction $f^T.z$ sont calculées et permettent de décider du prochain vecteur solution X.

Plus précisément, à chaque itération, l'algorithme d'optimisation équilibre les écarts d'énergie avec les variables d'ajustement $\partial 1_{jk}$, $\partial 2_{jk}$ de sorte que les égalités du système d'équation soient vérifiées. Ainsi, si l'énergie délivrée sur un départ d'indice j est excédentaire, on augmente la variable d'ajustement $\partial 1_{jk}$ correspondante et si cette énergie est déficitaire, on augmente la variable $\partial 2_{jk}$ correspondante. Ainsi, plus les paramètres de raccordement $a_{ij}$ respectent le principe de conservation de l'énergie, plus les variables d'ajustement sont faibles. L'objectif est de minimiser les variables d'ajustement, ce qui se traduit par la fonction objectif $f^T.z = \sum_{j=1}^{m} \sum_{k=1}^{w} (\partial 1_{jk} + \partial 2_{jk})$.

Les matrices $l_z$ et $u_z$ bornent les paramètres de raccordement $a_{ij}$ entre $-\varepsilon$ et $1+\varepsilon$ et les variables d'ajustement $\partial 1_{jk}$ et $\partial 2_{jk}$ entre 0 et $+\infty$. Plus précisément, lors de l'application de l'algorithme d'optimisation, les paramètres de raccordement $a_{ij}$ sont des nombres réels ce qui permet de relaxer les contraintes. Puis, suite à l'application de l'algorithme d'optimisation, le logiciel de détermination 48 est configuré pour fixer les valeurs des paramètres de raccordement $a_{ij}$ à 0 ou à 1 en fonction de leur valeur suite à l'application de l'algorithme d'optimisation. La valeur 0 indique un non raccordement du consommateur d'indice i au départ d'indice j, tandis que la valeur 1 indique un raccordement du consommateur d'indice i au départ d'indice j.

Le logiciel de détermination 48 est, par exemple, configuré pour déterminer les valeurs des paramètres de raccordement suite à l'application de l'algorithme d'optimisation via l'équation suivante :

$$a_{ij} = \begin{cases} 1 & \text{si} \quad a_{ij} = \max_{j}(a_{ij}) \\ 0 & \text{sinon} \end{cases} \qquad (7)$$

Ainsi, d'après l'équation (7) ci-dessus, chaque consommateur $16_i$ est raccordé à un seul départ $18_j$.

De plus, l'unité de traitement 24 est configuré pour identifier, en fonction des paramètres de raccordement déterminés et à partir, par exemple, d'un logiciel d'identification, non représenté, compris dans la mémoire 28, des sous-ensembles de consommateurs, avec chaque sous-ensemble de consommateurs qui correspond à l'ensemble des consommateurs $16_i$ raccordés à un même départ $18_j$.

En variante, le logiciel de détermination 48 est configuré pour déterminer les paramètres de raccordement séparément pour chaque départ et indépendamment des deuxièmes données relatives à l'énergie électrique acquises pour les autres départs.

Selon cette variante, un système d'équation optimal est déterminé pour chaque départ et l'algorithme d'optimisation est appliqué à chaque système d'équation optimal. On obtient ainsi m systèmes d'équation optimaux résolus indépendamment via l'algorithme d'optimisation.

Ainsi, pour le départ d'indice 1, le système d'équation optimal correspondant vérifie :

$$A1 * z1 = B1, \qquad (8)$$

$$\text{où } z1 = \begin{bmatrix} a_{11} \\ \vdots \\ a_{n1} \\ \partial 1_{11} \\ \vdots \\ \partial 1_{1w} \\ \partial 2_{11} \\ \vdots \\ \partial 2_{1w} \end{bmatrix}, \quad B1 = \begin{bmatrix} E_{D1}(t_1) \\ \vdots \\ E_{D1}(t_w) \end{bmatrix} \text{ et } A1 = [U\, I_w - I_w], \text{ avec } U = \begin{bmatrix} E_{C1}(t_1) & \cdots & E_{Cn}(t_1) \\ \vdots & \ddots & \vdots \\ E_{C1}(t_w) & \cdots & E_{Cn}(t_w) \end{bmatrix}.$$

Puis, selon cette variante, le logiciel de détermination 48 est, par exemple, propre à déterminer les valeurs des paramètres de raccordement via l'équation (7).

Selon une autre variante, le logiciel de détermination 48 est configuré pour déterminer les paramètres de raccordement pour chaque conducteur électrique de phase $32_j$, $34_j$, $36_j$ et non simplement pour chaque départ $18_j$. Selon cette autre variante, le système d'équation comprend alors autant d'équation que de conducteurs électriques de phase $32_j$, $34_j$, $36_j$ et les variables décrites ci-dessus et relatives à un départ spécifique j sont alors relatives à un conducteur de phase spécifique. Ainsi, les deuxièmes capteurs $22_j$ mesurent l'énergie électrique délivrée par chaque conducteur de phase $32_j$, $34_j$, $36_j$ et non chaque départ $18_j$, les paramètres de raccordement $a_{ij}$ sont déterminés pour chaque conducteur de phase $32_j$, $34_j$, $36_j$ et les variables d'ajustement sont déterminées pour chaque conducteur de phase $32_j$, $34_j$, $36_j$. Selon cette autre variante, on identifie par exemple chaque conducteur électrique par un indice et la variable j, présentée dans les équations ci-dessus, correspond alors à un indice de conducteur électrique de phase et variant de 1 à u, avec u le nombre de conducteur électriques de phase qui est égal à 3*m, soit 6 dans l'exemple de la figure 1.

Plusieurs modes de réalisation d'un procédé de détermination de la structure du réseau de distribution électrique 10, mis en oeuvre via l'unité de traitement 24, et plus globalement via le système de détermination 12, vont désormais être présentés.

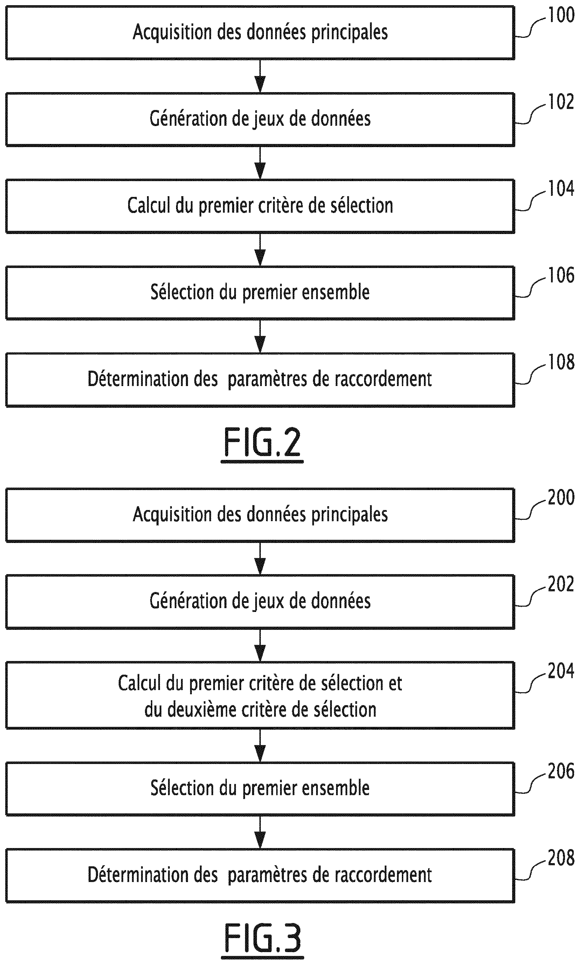

Selon un premier mode de réalisation décrit ci-après en référence à la figure 2, le procédé comprend une étape initiale 100 d'acquisition de données principales du réseau de distribution 10. Les données principales comprennent, par exemple, le nombre total n de consommateurs $16_i$, le nombre total m de départs $18_j$, les premières données $E_{Ci}(t_l)$ mesurées, les deuxièmes données $E_{Dj}(t_l)$ mesurées et les différents intervalles temporels $t_l$ associés aux premières et deuxièmes données mesurées. En effet, lors de l'étape initiale 100, le logiciel d'acquisition 41 commande, par exemple, la mesure, par chaque premier $20_i$ et chaque deuxième $22_j$ capteurs, des premières $E_{Ci}(t_l)$ et deuxièmes $E_{Dj}(t_l)$ données pendant les intervalles temporels $t_l$ et la transmission des premières $E_{Ci}(t_l)$ et deuxièmes $E_{Dj}(t_l)$ données qui sont alors associées à l'intervalle temporel $t_l$ pendant lequel elles ont été mesurées, via, par exemple, les premières et deuxièmes informations.

Ensuite, lors d'une étape de génération 102, le logiciel de génération 42 génère plusieurs jeux de données $Je_l$ différents, associés chacun à l'un des intervalles temporels $t_l$ et qui comprennent les premières $E_{Ci}(t_l)$ et deuxièmes $E_{Dj}(t_l)$ données associées audit intervalle temporel $t_l$.

Puis, lors d'une étape de calcul 104, le logiciel de calcul 44 calcule le premier critère de sélection $C1_l$ pour chaque jeu de données $Je_l$. Le premier critère de sélection $C1_l$ est par exemple le taux global de pertes d'énergie électrique entre les départs $18_j$ et les consommateurs $16_i$.

Ensuite, au cours d'une étape de sélection 106, le logiciel de sélection 46 sélectionne le premier ensemble $En_1$ en fonction des premiers critères de sélection $C1_l$ calculés. Le premier ensemble $En_1$ est sélectionné parmi les jeux de données générés à l'étape 102. Au cours de l'étape de sélection 106, le logiciel de sélection 46 compare, par exemple, les premiers critères $C1_l$ avec la première variable prédéterminée V1, la valeur de la première variable prédéterminée V1 étant par exemple définie lors de l'étape d'acquisition 100. Le logiciel de sélection 46 sélectionne alors les jeux de données $Je_l$ pour lesquels le premier critère $C1_l$ est inférieur à la première variable prédéterminée V1.

Enfin, au cours d'une étape de détermination 108, les paramètres de raccordement sont déterminés via le logiciel de détermination 48 et à partir du premier ensemble $En_1$ sélectionné.

Plus précisément, le logiciel de détermination 48 détermine le système d'équation à résoudre à partir, par exemple, de l'équation (4), comme présenté ci-dessus. Puis, comme présenté ci-dessus lors de la description du système de détermination 12 et de l'équation (5), l'algorithme d'optimisation est appliqué au système d'équation afin de déterminer les paramètres de raccordement $a_{ij}$.

En variante, lors de l'étape de détermination, le logiciel de détermination 48 détermine les systèmes d'équations optimaux, comme présenté ci-dessus via l'équation (8), et applique l'algorithme d'optimisation à chaque système d'équation optimal. La vitesse de détermination des paramètres de raccordement $a_{ij}$ est alors améliorée, puisque les systèmes d'équation optimaux comprennent un nombre limité d'équations.

Dans le premier mode de réalisation, le fait de réaliser une sélection des jeux de données $Je_k$ permet d'éliminer les jeux de données $Je_l$ pour lesquels les pertes sont les plus importantes, ces jeux de données risquant de conduire à une détermination erronée des paramètres de raccordement $a_{ij}$.

Ainsi, selon le premier mode de réalisation, les paramètres de raccordement déterminés $a_{ij}$, sont déterminés de manière plus certaine par rapport aux méthodes connues de l'état de la technique et la fiabilité du procédé de détermination est améliorée.

En outre, l'algorithme d'optimisation utilisé permet d'utiliser un nombre indifférent de jeux de données $Je_k$ lors de l'étape de détermination 108, même s'il est préférable que le nombre de jeux de données du premier ensemble soit supérieur ou égal au nombre total n de consommateurs $16_i$.

Selon un deuxième mode de réalisation de l'invention décrit ci-après en référence à la figure 3, le procédé comprend des étapes 200, 202, 204, 206, 208 identiques respectivement aux étapes 100, 102, 104, 106, 108 du premier mode de réalisation et, lors de l'étape 204, un deuxième critère de sélection $C2_l$ est calculé pour chaque jeu de données généré. Le deuxième critère de sélection $C2_l$ est différent du premier critère $C1_l$ et est choisi parmi un taux global de pertes d'énergie électrique entre le ou les départs et les consommateurs et un écart de consommation d'énergie électrique entre les différents consommateurs.

Ainsi, lors de l'étape 204, chaque premier critère $C1_l$ est, par exemple, le taux global de perte relatif au jeu de données $Je_l$ correspondant et chaque deuxième critère $C2_l$ est l'écart de consommation d'énergie électrique relatif au jeu de données $Je_l$ correspondant, et est calculé via l'équation (2) ou l'équation (3).

Puis, au cours de l'étape de sélection 206, le logiciel de sélection 46 sélectionne le premier ensemble $En_1$ en fonction des premiers critères de sélection $C1_l$ et des deuxièmes critères de sélection $C2_l$ calculés. Le premier ensemble $En_1$ est sélectionné parmi les jeux de données générés à l'étape 202. Au cours de l'étape de sélection 206, le logiciel de sélection 46 compare, par exemple, les premiers critères $C1_l$ avec la première variable V1 et les deuxièmes critères $C2_l$ avec une deuxième variable prédéterminée V2. La valeur de la deuxième variable prédéterminée V2 est, par exemple, définie lors de l'étape d'acquisition 200. Le logiciel de sélection 46 sélectionne alors les jeux de données pour lesquels le premier critère $C1_l$ est inférieur à la première variable prédéterminée V1 et le deuxième critère $C2_l$ est inférieur à la deuxième variable prédéterminée V2.

Enfin, au cours de l'étape de détermination 208 les paramètres de raccordement sont déterminés via le logiciel de détermination 48 et à partir du premier ensemble sélectionné $En_1$.

Le deuxième mode de réalisation permet d'affiner la sélection des jeux de données par rapport au premier mode de réalisation et ainsi de sélectionner des jeux de données à partir desquels le risque d'erreur dans la détermination des paramètres de raccordement $a_{ij}$ est minimisé. La justesse, la vitesse et la fiabilité du procédé de détermination sont ainsi améliorées.

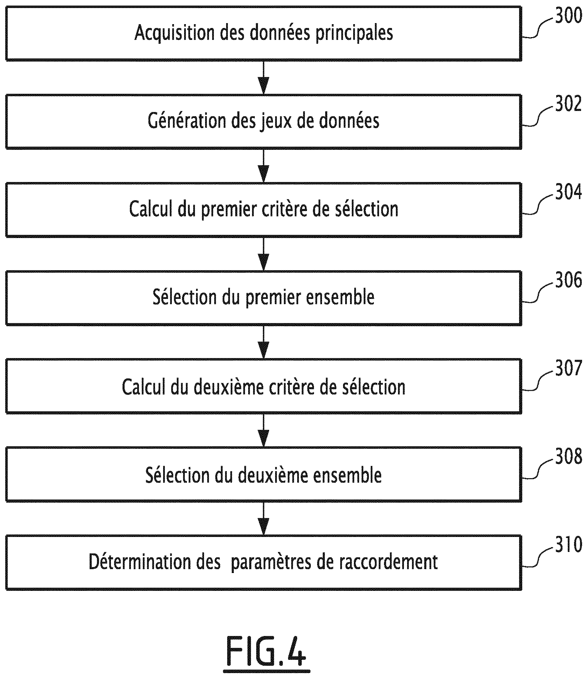

Selon un troisième mode de réalisation de l'invention décrit ci-après en référence à la figure 4, le procédé comprend des étapes 300, 302, 304, 306, 310 identiques respectivement aux étapes 100, 102, 104, 106, 108 du premier mode de réalisation et, suite à l'étape 306 et précédemment à l'étape 310, le procédé comprend une étape 307 de calcul d'un deuxième critère de sélection $C2_k$ pour chaque jeu de données du premier ensemble $En_1$, le deuxième critère $C2_k$ étant différent du premier critère et étant choisi parmi un taux global de pertes d'énergie électrique entre le ou les départs $18_j$ et les consommateurs $16_i$ et un écart de consommation d'énergie électrique entre les différents consommateurs $16_i$.

Dans le troisième mode de réalisation, chaque premier critère $C1_l$ est, par exemple, le taux global de perte relatif au jeu de données correspondant généré à l'étape 302 et chaque deuxième critère $C2_k$ est l'écart de consommation d'énergie électrique relatif au jeu de données correspondant du premier ensemble $En_1$.

Suite à l'étape de calcul 307, lors d'une étape de sélection 308, un deuxième ensemble $En_2$ de jeux de données est sélectionné parmi le premier ensemble $En_1$. Puis, le premier ensemble $En_1$ est, par exemple, fixé égal au deuxième ensemble sélectionné $En_2$ pour réaliser l'étape de détermination 310 en fonction du deuxième ensemble sélectionné $En_2$.

Le troisième mode de réalisation permet d'affiner la sélection des jeux de données par rapport au premier mode de réalisation, et ainsi de sélectionner des jeux de données à partir desquels le risque d'erreur dans la détermination des paramètres de raccordement $a_{ij}$ est minimisé. La justesse, la vitesse et la fiabilité du procédé de détermination sont ainsi améliorées.

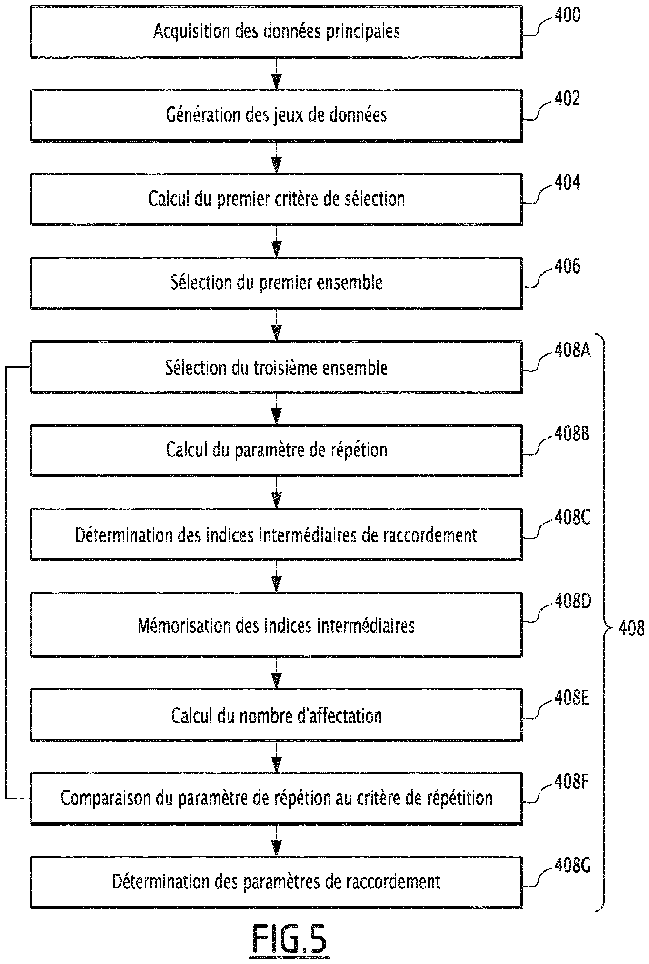

Selon un quatrième mode de réalisation de l'invention décrit ci-après en référence à la figure 5, le procédé comprend des étapes 400, 402, 404, 406 identiques aux étapes 100, 102, 104, 106 du premier mode de réalisation.

Puis, suite à l'étape de sélection 406, le procédé comprend une étape 408 de détermination des paramètres de raccordement. Plus précisément, lors de l'étape 408, le procédé comprend une première sous-étape 408A de sélection pseudo-aléatoire d'un troisième ensemble $En_3$ de jeux de données inclut dans le premier ensemble $En_1$.

Ensuite, lors d'une sous-étape de calcul 408B, un paramètre de répétition R1 est calculé. Le paramètre de répétition R1 correspond à un nombre d'itérations de la sous-étape de sélection 408A.

Puis, au cours d'une sous-étape de détermination 408C, des indices intermédiaires $b_{ij}$ de raccordement, indiquant pour chaque consommateur $16_i$ le départ $18_j$ auquel il est raccordé, sont déterminés à partir du troisième ensemble sélectionné $En_3$. Plus généralement, les indices intermédiaires $b_{ij}$ comportent pour chaque consommateur électrique $16_i$ un identifiant du départ 18j auquel il est raccordé. La sous-étape de détermination 408C est analogue à l'étape de détermination 108 du premier mode de réalisation, mais est réalisée à partir du troisième ensemble $En_3$.

Ensuite, lors d'une sous-étape de mémorisation 408D, les indices intermédiaires de raccordement $b_{ij}$ sont mémorisés par la mémoire 28.

Puis, au cours d'une sous-étape de calcul 408E, réalisée pour chaque consommateur $16_i$ et pour chaque départ $18_j$, un nombre d'affectation $NA_{ij}$ relatif au nombre de fois où les indices intermédiaires de raccordement mémorisés indiquent que le consommateur $16_i$ est raccordé au départ $18_j$ est calculé.

Le nombre d'affectation $NA_{ij}$ est par exemple calculé via la formule suivante : $NA_{ij} = \dfrac{N(b_{ij} = 1)}{N_T}$ , où $N(b_{ij}$

=1) correspond au nombre de fois où les indices intermédiaires $b_{ij}$ mémorisés sont égaux à 1 pour le consommateur $16_i$ d'indice i et le départ $18_j$ d'indice j et $N_T$ correspond à un nombre total d'itérations de la sous-étape de sélection 408A. Avantageusement, le nombre total d'itérations $N_T$ est initialisé à 0 précédemment à l'exécution de la sous-étape de sélection 408A et incrémenté de 1 à chaque exécution de la sous-étape de sélection.

Il est à noter que le nombre d'indices intermédiaires de raccordement mémorisés pour un consommateur électrique $16_i$ donné et un départ $18_j$ donné est égal au nombre d'itérations de la sous-étape de sélection 408A

Avantageusement, les nombres d'affectation calculés sont mémorisés suite à la sous-étape de calcul 408E.

Puis, lors d'une sous-étape de comparaison 408F, le paramètre de répétition R1 est comparé à un critère de répétition prédéterminé CR1. Le critère de répétition prédéterminé CR1 est, par exemple, initialisé lors de l'étape d'acquisition 400.

Le critère de répétition CR1 est, par exemple, un nombre minimal d'itérations de la sous-étape de sélection 408A.

Si lors de la sous-étape de comparaison 408F, le paramètre de répétition est inférieur au critère de répétition, alors les étapes de sélection 408A, de calcul 408B, de détermination 408C, de mémorisation 408D, de calcul 408E et de comparaison 408F sont répétées.

Si lors de la sous-étape de comparaison 408F, le paramètre de répétition R1 est supérieur au critère de répétition CR1, alors une sous-étape 408G de détermination des paramètres de raccordement $a_{ij}$ est effectuée.

Lors de la sous-étape de détermination 408G, les paramètres de raccordement $a_{ij}$ sont déterminés à partir du ou des troisièmes ensembles sélectionnés $En_3$, et plus précisément en fonction des indices intermédiaires de raccordement $b_{ij}$ mémorisés lors de la sous-étape de mémorisation 408D, et plus précisément encore en fonction des nombres d'affectation $NA_{ij}$ calculés à la dernière itération de la sous-étape 408E. Plus précisément, pour chaque consommateur électrique $16_i$, l'indice de départ j correspondant au nombre d'affectation $NA_{ij}$ le plus grand est identifié, et le paramètre de raccordement $a_{ij}$ correspondant audit consommateur $16_i$ et audit départ $18_j$ est fixé égal à 1, les autres paramètres de raccordement $a_{ij}$ relatifs audit consommateur étant fixés égaux à 0.

Avantageusement, si lors de la sous-étape de détermination 408G tous les nombres d'affectation relatifs à un consommateur $16_i$ sont inférieurs à un premier seuil prédéterminé S1, par exemple égal à 0,6, alors une erreur d'identification du raccordement pour ledit consommateur $16_i$ est identifiée.

En variante, si le nombre d'itérations de la sous-étape 408A est supérieur à 2, alors, lors de la sous-étape de calcul 408E, et à chaque itération de la sous-étape 408E, une première moyenne des nombres d'affectation $NA_{ij}$, calculés à chaque itération de la sous-étape 408E, pour chaque consommateur $16_i$ et pour chaque départ $18_j$, est calculée. Puis, une deuxième moyenne des nombres d'affectation $NA_{ij}$, calculés à la dernière itération, pour chaque consommateur $16_i$ et pour chaque départ $18_j$,, est calculée. Ensuite, lors de la sous-étape 408E, une différence entre la première moyenne et la deuxième moyenne est calculée.

La première et la deuxième moyenne sont, par exemple, des moyennes arithmétiques, géométriques ou quadratiques...

Selon cette variante, lors de la sous-étape de comparaison 408F, la valeur absolue de la dernière différence calculée est comparée à un deuxième seuil prédéterminé S2, par exemple égal à 0,1. Puis, si lors de la sous-étape de comparaison 408F, le paramètre de répétition R1 est supérieur au critère de répétition CR1 et la valeur absolue de la dernière différence calculée est inférieure au deuxième seuil S2, alors la sous-étape 408G est effectuée. Sinon, les étapes 408A, 408B, 408C, 408D, 408E et 408F sont réitérées.

Le quatrième mode de réalisation permet, notamment lorsque le nombre d'itérations de la sous-étape 408A est supérieur à 2, de déterminer les paramètres de raccordement $a_{ij}$ à partir de troisièmes ensembles $En_3$ de jeux de données différents. Ainsi, la justesse et la fiabilité du procédé de détermination sont améliorées.

En outre, le quatrième mode de réalisation permet avantageusement d'identifier chaque consommateur $16_i$ pour lequel le départ associé 18j est déterminé avec un bon indice de confiance et chaque consommateur $16_i$ pour

lequel le départ associé 18j est indéterminé ou déterminé avec un mauvais indice de confiance. En effet, comme présenté ci-dessus, si lors de la sous-étape de détermination 408G tous les nombres d'affectation relatifs à un consommateur $16_i$ sont inférieurs au premier seuil prédéterminé S1, par exemple égal à 0,6, alors une erreur d'identification du raccordement pour ledit consommateur $16_i$ est identifiée et le départ 18j auquel est raccordé le consommateur $16_i$ est indéterminé. De la même manière, si lors de la sous-étape de détermination 408G un nombre d'affectation relatif à un consommateur $16_i$ est supérieur à un troisième seuil prédéterminé S3, par exemple égal à 0,95, alors le raccordement du consommateur $16_i$ au départ 18j correspondant est identifié avec un bon indice de confiance.

Avantageusement encore, le quatrième mode de réalisation permet d'associer, à chaque paramètre de raccordement $a_{ij}$, fixé égal à 1 lors de la sous-étape de détermination 408G, un indice de confiance représentant la probabilité que le raccordement déterminé soit correct. L'indice de confiance est par exemple égal au nombre d'affectation $NA_{ij}$ correspondant.

Les modes de réalisations et variantes envisagées ci-dessus sont propres à être combinées entre eux, selon toutes combinaisons techniquement admissibles, pour donner lieu à d'autres modes de réalisation de l'invention.

Ainsi, le deuxième mode de réalisation est propre à être combiné avec le quatrième mode de réalisation et le troisième mode de réalisation est également propre à être combiné avec le quatrième mode de réalisation.


## Revendications

1.   Procédé de détermination de la structure d'un réseau (10) de distribution d'électricité, le procédé étant mis en oeuvre par ordinateur (24), le réseau de distribution comprenant un poste d'alimentation (14) comportant un ou plusieurs départs ($18_j$) d'alimentation en énergie électrique de plusieurs consommateurs électriques ($16_i$) et comprenant les étapes suivantes :

   - a) l'acquisition (100 ; 200 ; 300 ; 400), pour chaque consommateur électrique ($16_i$), de premières données ($E_{Ci}(t_l)$) relatives à l'énergie électrique consommée par le consommateur électrique ($16_i$) pendant différents intervalles temporels ($t_l$), mesurées via un premier capteur ($20_i$) de mesure d'énergie,
   - b) l'acquisition (100 ; 200 ; 300 ; 400), pour chaque départ ($18_j$), de deuxièmes données ($E_{Dj}(t_l)$) relatives à l'énergie électrique délivrée par le départ ($18_j$) pendant les différents intervalles temporels ($t_l$), mesurées via un deuxième capteur ($20_j$) de mesure d'énergie,
   - c) la génération (102 ; 202 ; 302 ; 402), via un module de génération (42), de plusieurs jeux de données ($Je_l$) différents, associés chacun à l'un des intervalles temporels différents, chaque jeu de données ($Je_l$) comprenant les premières ($E_{Ci}(t_l)$) et deuxièmes ($E_{Dj}(t_l)$) données associées audit intervalle temporel ($t_l$),

   **caractérisé en ce que** le procédé comprend en outre les étapes suivantes :

   - d) le calcul (104 ; 204 ; 304 ; 404) d'un premier critère de sélection ($C1_l$) pour chaque jeu de données, le premier critère de sélection ($C1_l$) étant un critère choisi parmi un taux global de pertes d'énergie électrique entre le ou les départs ($18_j$) et les consommateurs ($16_i$) et un écart de consommation d'énergie électrique entre les différents consommateurs ($16_i$),
   - e) la sélection (106; 206; 306; 406), par une unité de sélection (46) et en fonction des premiers critères de sélection ($C1_l$) calculés, d'un premier ensemble ($En_1$) de jeux de données ($Je_k$) parmi les jeux générés ($Je_l$),
   - f) la détermination (108 ; 208 ; 310 ; 408), à partir du premier ensemble (En1) sélectionné, de paramètres de raccordement ($a_{ij}$), lesdits paramètres ($a_{ij}$) comportant pour chaque consommateur électrique ($16_i$) un identifiant du départ ($18_i$) auquel il est raccordé.

2.   Procédé selon la revendication 1, dans lequel, lors de l'étape de calcul d) (204), un deuxième critère de sélection ($C2_l$) pour chaque jeu de données ($Je_l$) généré est calculé, le deuxième critère ($C2_l$) étant l'autre critère choisi parmi un taux global de pertes d'énergie électrique entre le ou les départs ($18_j$) et les consommateurs ($16_i$) et un écart de consommation d'énergie électrique entre les différents consommateurs ($16_i$),
   et dans lequel, lors de l'étape de sélection e) (206), le premier ensemble (En1) est sélectionné en fonction des premiers ($C1_l$) et deuxièmes ($C2_l$) critères calculés.

3.   Procédé selon la revendication 1, dans lequel, suite à l'étape de sélection e), le procédé comprend les étapes suivantes :

   - e1) le calcul (307) d'un deuxième critère de sélection ($C2_l$) pour chaque jeu de données ($Je_k$) du premier ensemble (En1), le deuxième critère ($C2_l$) étant l'autre critère choisi parmi un taux global de pertes d'énergie électrique entre le ou les départs (18$_j$) et les consommateurs (16$_i$) et un écart de consommation d'énergie électrique entre les différents consommateurs (16$_i$),
- e2) la sélection (308) en fonction des deuxièmes critères de sélection (C2$_l$) calculés d'un deuxième ensemble (En$_2$) de jeux de données parmi le premier ensemble (En1),

la détermination des paramètres de raccordement (a$_{ij}$) étant alors effectuée lors de l'étape de détermination f) (310) en fonction du deuxième ensemble (En$_2$) sélectionné parmi le premier ensemble (En1).

4. Procédé selon l'une des revendications précédentes, dans lequel, lors de l'étape de détermination f) (108 ; 208 ; 310 ; 408), les paramètres de raccordement (a$_{ij}$) sont déterminés séparément pour chaque départ (18$_j$) et indépendamment des deuxièmes données (E$_{Dj}$(t$_l$)) relatives à l'énergie électrique acquises pour les autres départs (18$_j$).

5. Procédé selon l'une des revendications précédentes, dans lequel, lors de l'étape de détermination f) (108 ; 208 ; 310 ; 408), un système d'équation à résoudre est déterminé à partir d'un postulat de conservation de l'énergie électrique pour chaque départ (18$_j$) selon lequel l'énergie délivrée par le départ (18$_j$) est sensiblement égale à la somme de l'énergie consommée par les consommateurs électriques (16$_i$) connectés au départ (18$_j$) et des pertes électriques.

6. Procédé selon la revendication 5, dans lequel, lors de l'étape de détermination f) (108 ; 208 ; 310 ; 408), le système d'équation est défini à partir de l'équation suivante :

$$E_{Dj}(t_k) = \sum_{i=1}^{n} (a_{ij}.E_{Ci}(t_k) + \partial 1_{jk} - \partial 2_{jk}),$$

où n est le nombre de consommateurs électriques (16$_i$), j est un indice de départ (18$_j$) variant de 1 à m, m étant le nombre de départs (18$_j$), i est un indice de consommateur électrique variant de 1 à n,
k est un indice de jeu de données (Je$_k$) du premier ensemble (En$_1$)variant de 1 à w, w étant le nombre de jeux de données (Je$_k$) du premier ensemble (En1), t$_k$ est l'intervalle temporel associé au jeu de données (Je$_k$) d'indice k,
a$_{ij}$ est le paramètre de raccordement indiquant si le consommateur (16$_i$) d'indice i est raccordé au départ (18$_j$) d'indice j,
E$_{Ci}$(t$_k$) est l'énergie électrique consommée par le consommateur électrique (16$_i$) d'indice i pendant l'intervalle temporel t$_k$,
E$_{Dj}$(t$_k$) est l'énergie électrique délivrée par le départ (18$_j$) d'indice j pendant l'intervalle temporel t$_k$, et
$\partial 1_{jk}$ et $\partial 2_{jk}$ sont des variables d'ajustement représentatives des pertes électriques.

7. Procédé selon la revendication 6, dans lequel le système d'équation s'écrit sous une forme matricielle de la manière suivante : A*z= B, où $z = \begin{bmatrix} a_{11} \\ \vdots \\ a_{n1} \\ \vdots \\ a_{1m} \\ \vdots \\ a_{nm} \\ \partial 1_{11} \\ \vdots \\ \partial 1_{mw} \\ \partial 2_{11} \\ \vdots \\ \partial 2_{mw} \end{bmatrix}$ , $B = \begin{bmatrix} E_{D1}(t_1) \\ \vdots \\ E_{D1}(t_w) \\ E_{D2}(t_1) \\ \vdots \\ E_{D2}(t_w) \\ E_{Dm}(t_1) \\ \vdots \\ E_{Dm}(t_k) \end{bmatrix}$ et $A = \begin{bmatrix} U & 0 & \cdots & 0 \\ 0 & \ddots & \ddots & \vdots \\ \vdots & \ddots & \ddots & 0 \\ 0 & \cdots & 0 & U \end{bmatrix}$ avec

$U = \begin{bmatrix} E_{C1}(t_1) & \cdots & E_{Cn}(t_1) \\ \vdots & \ddots & \vdots \\ E_{C1}(t_w) & \cdots & E_{Cn}(t_w) \end{bmatrix}$ et A comprenant m*n colonnes et m*w lignes.

8. Procédé selon la revendication 7, dans lequel, lors l'étape de détermination, un algorithme d'optimisation est utilisé pour résoudre le système d'équation, l'algorithme d'optimisation vérifiant :

$$\min_z f^T.z \quad \text{tel que} \quad \begin{cases} A.z = B \\ l_z \le z \le u_z \end{cases},$$

où $f^T.z = \begin{bmatrix} \underbrace{0 \quad \cdots \quad 0}_{m*n} & \underbrace{1 \quad \cdots \quad 1}_{w*m} & \underbrace{1 \quad \cdots \quad 1}_{w*m} \end{bmatrix} \times z$,

$$l_z = \begin{bmatrix} -\varepsilon \\ \vdots \\ -\varepsilon \\ 0 \\ \vdots \\ 0 \end{bmatrix} \text{ et } u_z = \begin{bmatrix} 1+\varepsilon \\ \vdots \\ 1+\varepsilon \\ +\infty \\ \vdots \\ +\infty \end{bmatrix},$$

avec $\varepsilon$ compris entre 0 et 0,5.

9. Procédé selon l'une des revendications précédentes, dans lequel chaque départ ($18_j$) comprend un ou plusieurs conducteurs électriques de phase, et dans lequel, lors de l'étape d'acquisition b), les deuxièmes données ($E_{Dj}(t_l)$) sont acquises pour chaque conducteur électrique de phase et sont relatives à l'énergie électrique délivrée par chaque conducteur électrique de phase, et, lors de l'étape de détermination f) (108 ; 208 ; 310 ; 408), les paramètres de raccordement ($a_{ij}$) déterminés comportent pour chaque consommateur électrique ($16_j$) un identifiant du ou des conducteurs électriques de phase auxquels il est raccordé.

10. Procédé selon l'une des revendications précédentes, dans lequel, lors de l'étape de détermination f) (408), le procédé comprend les étapes suivantes :

- f1) la sélection (408A) pseudo-aléatoire d'un troisième ensemble (En$_3$) de jeux de données inclus dans le premier ensemble (En$_1$),
- f2) la détermination (408G) des paramètres de raccordement (a$_{ij}$) à partir du troisième ensemble (En$_3$) sélectionné parmi le premier ensemble (En$_1$).

11. Procédé selon la revendication 10, dans lequel, suite à l'étape f1) de sélection (408A) et précédemment à l'étape de détermination f2) (408G), le procédé comprend les étapes suivantes :

- f3) le calcul (408B) d'un paramètre de répétition (R1),
- f4) la détermination (408C), à partir du troisième ensemble (En$_3$) sélectionné, d'indices intermédiaires de raccordement (b$_{ij}$) comportant pour chaque consommateur électrique (16$_i$) un identifiant du départ (18$_j$) auquel il est raccordé,
- f5) la mémorisation (408D) des indices intermédiaires de raccordement (b$_{ij}$), et
- f6) la comparaison (408F) du paramètre de répétition avec au moins un critère de répétition prédéterminés (CR1),

et, suivant le résultat de l'étape de comparaison f6) (408F), la réalisation d'une étape parmi, d'une part, la répétition des étapes de sélection f1), de calcul f3), de détermination f4), de mémorisation f5) et de comparaison f6) et, d'autre part, l'étape de détermination f2) des paramètres de raccordement (a$_{ij}$) en fonction des indices intermédiaires de raccordement (b$_{ij}$) mémorisés.

12. Procédé selon la revendication 11, dans lequel, le procédé comprend l'étape suivante :

- f7) le calcul (408E), pour chaque consommateur (16$_i$) et pour chaque départ (18$_j$), d'un nombre d'affectation (NA$_{ij}$) relatif au nombre de fois où les indices intermédiaires de raccordement (b$_{ij}$) mémorisés indiquent que le consommateur (16$_i$) est raccordé au départ (18$_j$),

et dans lequel, lors de l'étape de détermination f2) (408G), les paramètres de raccordement (a$_{ij}$) sont déterminés à partir des nombres d'affectation (NA$_{ij}$) calculés.

13. Programme d'ordinateur comportant des instructions logicielles, qui lorsqu'elles sont exécutées par un ordinateur mettent en oeuvre le procédé selon l'une quelconque des revendications précédentes.

14. Système (12) de détermination de la structure d'un réseau (10) de distribution d'électricité, le réseau de distribution (10) comprenant un poste d'alimentation comportant un ou plusieurs départs (18$_j$) d'alimentation en énergie électrique de plusieurs consommateurs électriques (16$_i$), le système comprenant :

- pour chaque consommateur électrique (16$_i$), un premier capteur (20$_i$) de mesure de premières données (E$_{Ci}$(t$_l$)) relatives à l'énergie électrique consommée par le consommateur (16$_i$) pendant différents intervalles temporels (t$_l$),
- pour chaque départ (18$_j$), un deuxième capteur (22$_j$) de mesure de deuxièmes données (E$_{Dj}$(t$_l$)) relatives à l'énergie électrique délivrée par le départ (18$_j$) pendant les différents intervalles temporels (t$_l$),
- un module (41) d'acquisition des premières (E$_{Ci}$(t$_l$)) et deuxièmes (E$_{Dj}$(t$_l$)) données,
- un module (42) de génération de plusieurs jeux de données (Je$_l$) différents, associés chacun à l'un des intervalles temporels différents (t$_l$), chaque jeux de données (Je$_l$) comprenant les premières (E$_{Ci}$(t$_l$)) et deuxièmes (E$_{Ci}$(t$_l$)) données associées audit intervalle temporel (t$_l$),

**caractérisé en ce que** le système de détermination (12) comprend en outre :

- un module (44) de calcul d'un premier critère de sélection (C1$_l$) pour chaque jeu (Je$_l$) de données, le premier critère de sélection (C1$_l$) étant un critère choisi parmi un taux global de pertes d'énergie électrique entre le ou les départs (18$_j$) et les consommateurs (16$_i$) et un écart de consommation d'énergie électrique entre les différents consommateurs (16$_i$),
- un module (46) de sélection, en fonction des premiers critères de sélection (C1$_l$) calculés, d'un premier ensemble (En$_1$) de jeux de données (Je$_k$) parmi les jeux générés, et
- un module (48) détermination, à partir du premier ensemble (En$_1$) sélectionné, de paramètres de raccordement

($a_{ij}$), lesdits paramètres ($a_{ij}$) comportant pour chaque consommateur électrique ($16_i$) un identifiant du départ ($18_j$) auquel il est raccordé.

**Patentansprüche**

1. Verfahren zum Bestimmen der Struktur eines Stromverteilungsnetzes (10), wobei das Verfahren von einem Computer (24) ausgeführt wird, wobei das Verteilungsnetz eine Versorgungsstation (14) mit einem oder mehreren Abgängen ($18_j$) für die Versorgung mit elektrischer Energie von mehreren elektrischen Verbrauchern ($16_i$) enthält, und das die folgenden Schritte umfasst:

   a) Erfassen (100; 200; 300; 400) für jeden elektrischen Verbraucher ($16_i$) erster Daten ($E_{Ci}(t_l)$), die auf die von dem elektrischen Verbraucher ($16_i$) während verschiedener Zeitintervalle ($t_l$) verbrauchte elektrische Energie bezogen sind und über einen ersten Energiemesssensor ($20_i$) gemessen wird,
   b) Erfassen (100, 200, 300, 400) für jeden Abgang ($18_j$) zweiter Daten ($E_{Dj}(t_l)$), die auf die elektrische Energie bezogen sind, die von dem Abgang ($18_j$) während der verschiedenen Zeitintervalle ($t_l$) geliefert wird und über einen zweiten Energiemesssensor ($20_j$) gemessen wird,
   c) Erzeugen (102; 202; 302; 402) über ein Erzeugungsmodul (42) von mehreren verschiedenen Datensätzen ($Je_l$), die jeweils einem der verschiedenen Zeitintervalle zugeordnet sind,

   wobei jeder Datensatz ($Je_l$) die ersten ($E_{Ci}(t_l)$) und die zweiten ($E_{Dj}(t_l)$) Daten, die dem Zeitintervall ($t_l$) zugeordnet sind, enthält,
   **dadurch gekennzeichnet, dass** das Verfahren außerdem die folgenden Schritte umfasst:

   d) Berechnen (104; 204; 304; 404) eines ersten Auswahlkriteriums ($C1_l$) für jeden Datensatz, wobei das erste Auswahlkriterium ($C1_l$) ein Kriterium ist, das aus einem globalen Anteil von Verlusten an elektrischer Energie zwischen dem einen oder den mehreren Abgängen ($18_j$) und den Verbrauchern ($16_i$) und aus einem Unterschied des Verbrauchs an elektrischer Energie zwischen den verschiedenen Verbrauchern ($16_i$) gewählt ist,
   e) Auswählen (106; 206; 306; 406) durch eine Auswahleinheit (46) und als Funktion der ersten berechneten Auswahlkriterien ($C1_l$) einer ersten Gesamtheit ($En_l$) von Datensätzen ($Je_k$) unter den erzeugten Sätzen ($Je_l$),
   f) Bestimmen (108; 208; 310; 408) anhand der gewählten ersten Gesamtheit ($En_l$) von Verbindungsparametern ($a_{ij}$), wobei die Parameter ($a_{ij}$) für jeden elektrischen Verbraucher ($16_i$) eine Kennung des Abgangs ($18_j$), mit dem er verbunden ist, enthalten.

2. Verfahren nach Anspruch 1, wobei im Berechnungsschritt d) (204) ein zweites Auswahlkriterium ($C2_l$) für jeden erzeugten Datensatz ($Je_l$) berechnet wird, wobei das zweite Kriterium ($C2_l$) das andere Kriterium ist, das aus dem globalen Anteil an Verlusten von elektrischer Energie zwischen dem einen oder den mehreren Abgängen ($18_j$) und den Verbrauchern ($16_i$) und einem Unterschied des Verbrauchs an elektrischer Energie zwischen den verschiedenen Verbrauchern ($16_i$) gewählt wird,
   und wobei im Auswahlschritt e) (206) die erste Gesamtheit ($En_l$) als Funktion der ersten ($C1_l$) und der zweiten ($C2_l$) berechneten Kriterien ausgewählt wird.

3. Verfahren nach Anspruch 1, wobei nach dem Auswahlschritt e) das Verfahren die folgenden Schritte umfasst:

   e1) Berechnen (307) eines zweiten Auswahlkriteriums ($C2_l$) für jeden Datensatz ($Je_k$) der ersten Gesamtheit ($En_l$), wobei das zweite Kriterium ($C2_l$) das andere Kriterium ist, das aus dem globalen Anteil von Verlusten an elektrischer Energie zwischen dem einen oder den mehreren Abgängen ($18_j$) und den Verbrauchern ($16_i$) und aus einem Unterschied des Verbrauchs von elektrischer Energie zwischen den verschiedenen Verbrauchern ($16_i$) gewählt wird,
   e2) Auswählen (308) als Funktion der zweiten berechneten Auswahlkriterien ($C2_l$) einer zweiten Gesamtheit ($En_2$) von Datensätzen aus der ersten Gesamtheit ($En_1$),

   wobei das Bestimmen von Verbindungsparametern ($a_{ij}$) dann im Bestimmungsschritt f) (310) als Funktion der zweiten Gesamtheit ($En_2$), die aus der ersten Gesamtheit ($En_1$) gewählt wird, ausgeführt wird.

4. Verfahren nach einem der vorhergehenden Ansprüche, wobei im Bestimmungsschritt f) (108; 208, 310; 408) die Verbindungsparameter ($a_{ij}$) getrennt für jeden Abgang ($18_j$) und unabhängig von zweiten Daten ($E_{Dj}(t_1)$), die auf die für die anderen Abgänge ($18_j$) erfasste elektrische Energie bezogen sind, bestimmt werden.

**5.** Verfahren nach einem der vorhergehenden Ansprüche, wobei im Bestimmungsschritt f) (108; 208; 310; 408) ein zu lösendes Gleichungssystem anhand eines Postulats der Erhaltung elektrischer Energie für jeden Abgang ($18_j$), gemäß dem die von dem Abgang ($18_j$) abgegebene Energie im Wesentlichen gleich der Summe aus der Energie, die von den mit dem Abgang (18j) verbundenen elektrischen Verbrauchern ($16_i$) verbraucht wird, und aus elektrischen Verlusten ist, bestimmt wird.

**6.** Verfahren nach Anspruch 5, wobei im Bestimmungsschritt f) (108; 208; 310; 408) das Gleichungssystem anhand der folgenden Gleichung definiert ist:

$$E_{Dj}(t_k) = \sum_{i=1}^{n}(a_{ij}.E_{Ci}(t_k) + \partial 1_{jk} - \partial 2_{jk})$$

wobei n die Anzahl elektrischer Verbraucher ($16_i$) ist, j ein Index des Abgangs ($18_j$) ist, der von 1 bis m läuft, m die Anzahl von Abgängen ($18_j$) ist und i ein Index des elektrischen Verbrauchers ist, der von 1 bis n läuft, k ein Index des Datensatzes ($Je_k$) der ersten Gesamtheit ($En_1$) ist, der von 1 bis w läuft, wobei w die Anzahl von Datensätzen ($Je_k$) der ersten Gesamtheit ($En_1$) ist, und wobei $t_k$ das Zeitintervall ist, das dem Datensatz ($Je_k$) mit Index k zugeordnet ist,
$a_{ij}$ der Verbindungsparameter ist, der angibt, ob der Verbraucher ($16_i$) mit Index i mit dem Abgang ($18_j$) mit Index j verbunden ist,
($E_{Ci}(t_k)$) die elektrische Energie ist, die von dem elektrischen Verbraucher ($16_i$) mit Index i während des Zeitintervalls $t_k$ verbraucht wird,
($E_{Dj}(t_k)$) die elektrische Energie ist, die von dem Abgang ($18_j$) mit Index j während des Zeitintervalls $t_k$ geliefert wird, und
$\partial 1_{jk}$ und $\partial 2_{jk}$ Einstellvariablen sind, die die elektrischen Verluste repräsentieren.

**7.** Verfahren nach Anspruch 6, wobei das Gleichungssystem in Matrixform folgendermaßen geschrieben wird: A*z = B, wobei

$$z = \begin{bmatrix} a_{11} \\ \vdots \\ a_{n1} \\ \vdots \\ a_{1m} \\ \vdots \\ a_{nm} \\ \partial 1_{11} \\ \vdots \\ \partial 1_{mw} \\ \partial 2_{11} \\ \vdots \\ \partial 2_{mw} \end{bmatrix}, \quad B = \begin{bmatrix} E_{D1}(t_1) \\ \vdots \\ E_{D1}(t_w) \\ E_{D2}(t_1) \\ \vdots \\ E_{D2}(t_w) \\ E_{Dm}(t_1) \\ \vdots \\ E_{Dm}(t_k) \end{bmatrix} \text{ und } A = \begin{bmatrix} U & 0 & \cdots & 0 \\ 0 & \ddots & \ddots & \vdots \\ \vdots & \ddots & \ddots & 0 \\ 0 & \cdots & 0 & U \end{bmatrix},$$

mit

$$U = \begin{bmatrix} E_{C1}(t_1) & \cdots & E_{Cn}(t_1) \\ \vdots & \ddots & \vdots \\ E_{C1}(t_w) & \cdots & E_{Cn}(t_w) \end{bmatrix}$$

wobei A m × n Spalten und m × w Zeilen enthält.

8. Verfahren nach Anspruch 7, wobei im Bestimmungsschritt ein Optimierungsalgorithmus verwendet wird, um das Gleichungssystem zu lösen, wobei der Optimierungsalgorithmus verifiziert:

$$\min_{z} f^{T}.z \quad, \text{derart, dass} \quad \begin{cases} A.z = B \\ l_z \leq z \leq u_z \end{cases},$$

wobei

$$f^{T}.z = \underbrace{[0 \quad \cdots \quad 0}_{m*n} \quad \underbrace{1 \quad \cdots \quad 1}_{w*m} \quad \underbrace{1 \quad \cdots \quad 1]}_{w*m} \times z \quad, \qquad l_z = \begin{bmatrix} -\varepsilon \\ \vdots \\ -\varepsilon \\ 0 \\ \vdots \\ 0 \end{bmatrix} \text{ und } \quad u_z = \begin{bmatrix} 1+\varepsilon \\ \vdots \\ 1+\varepsilon \\ +\infty \\ \vdots \\ +\infty \end{bmatrix},$$

mit $\varepsilon$ im Bereich von 0 bis 0,5.

9. Verfahren nach einem der vorhergehenden Ansprüche, wobei jeder Abgang ($18_j$) einen oder mehrere elektrische Phasenleiter umfasst und wobei im Erfassungsschritt b) die zweiten Daten ($E_{Dj}(t_1)$) für jeden elektrischen Phasenleiter erfasst werden und mit der elektrischen Energie in Beziehung stehen, die von jedem elektrischen Phasenleiter geliefert wird, und wobei im Bestimmungsschritt f) (108; 208; 310; 408) die bestimmten Verbindungsparameter ($a_{ij}$) für jeden elektrischen Verbraucher ($16_i$) eine Kennung des einen oder der mehreren elektrischen Phasenleiter, mit denen er verbunden ist, enthalten.

10. Verfahren nach einem der vorhergehenden Ansprüche, wobei im Bestimmungsschritt f) (408) das Verfahren die folgenden Schritte umfasst:

   f1) pseudozufälliges Auswählen (408A) einer dritten Gesamtheit ($En_3$) von Datensätzen, die in der ersten Gesamtheit ($En_1$) enthalten sind,
   f2) Bestimmen (408G) der Verbindungsparameter ($a_{ij}$) anhand der dritten Gesamtheit ($En_3$), die aus der ersten Gesamtheit ($En_1$) gewählt wird.

11. Verfahren nach Anspruch 10, wobei nach dem Auswahlschritt f1) (408A) und vor dem Bestimmungsschritt f2) (408G) das Verfahren die folgenden Schritte umfasst:

   f3) Berechnen (408B) eines Wiederholungsparameters (R1),
   f4) Bestimmen (408C) anhand der dritten gewählten Gesamtheit ($En_3$) von Verbindungszwischenindizes ($b_{ij}$), die für jeden elektrischen Verbraucher ($16_i$) eine Kennung des Abgangs $18_j$), mit dem er verbunden ist, enthalten,
   f5) Speichern (408D) der Verbindungszwischenindizes ($b_{ij}$) und
   f6) Vergleichen (408F) des Wiederholungsparameters mit wenigstens einem vorgegebenen Wiederholungskriterium (CR1),

   und entsprechend dem Ergebnis des Vergleichsschrittes f6) (408F) Ausführen eines Schrittes, der ausgewählt wird einerseits aus der Wiederholung der Schritte des Auswählens f1), des Berechnens f3), des Bestimmens f4), des Speicherns f5) und des Vergleichens f6) und andererseits aus dem Schritt des Bestimmens f2) der Verbindungsparameter ($a_{ij}$) als Funktion der gespeicherten Verbindungszwischenindizes ($b_{ij}$).

12. Verfahren nach Anspruch 11, wobei das Verfahren den folgenden Schritt umfasst:

   f7) Berechnen (408E) für jeden Verbraucher ($16_i$) und für jeden Abgang $18_j$) einer Anzahl von Zuweisungen

(NA$_{ij}$), die auf die Anzahl bezogen ist, in der die gespeicherten Verbindungszwischenindizes (b$_{ij}$) angeben, dass der Verbraucher (16$_i$) mit dem Abgang 18$_j$) verbunden ist,

und wobei im Bestimmungsschritt f2) (408G) die Verbindungsparameter (a$_{ij}$) anhand der berechneten Zuweisungsanzahlen (NA$_{ij}$) bestimmt werden.

13. Computerprogramm, das Software-Befehle enthält, die dann, wenn sie von einem Computer ausgeführt werden, das Verfahren nach einem der vorhergehenden Ansprüche ausführen.

14. System (12) zum Bestimmen der Struktur eines Stromverteilungsnetzes (10), wobei das Verteilungsnetz (10) eine Versorgungsstation umfasst, die einen oder mehrere Abgänge (18$_j$) für die Versorgung mit elektrischer Energie von mehreren elektrischen Verbrauchern (16$_i$) enthält, wobei das System Folgendes umfasst:

- für jeden elektrischen Verbraucher (16$_i$) einen ersten Sensor (20$_i$) zum Messen erster Daten (E$_{Ci}$(t$_1$)), die auf die elektrische Energie bezogen sind, die von dem Verbraucher (16$_i$) während verschiedener Zeitintervalle (t$_1$) verbraucht wird,
- für jeden Abgang (18$_j$) einen zweiten Sensor (22$_j$) zum Messen zweiter Daten (E$_{Dj}$(t$_1$), die auf die elektrische Energie bezogen sind, die von dem Abgang 18$_j$) während der verschiedenen Zeitintervalle (t$_1$) geliefert wird,
- ein Modul (41) zum Erfassen der ersten (E$_{Ci}$(t$_1$)) und der zweiten (E$_{Dj}$(t$_1$)) Daten,
- ein Modul (42) zum Erzeugen mehrerer verschiedener Datensätze (Je$_1$), die jeweils einem der verschiedenen Zeitintervalle (t$_1$) zugeordnet sind, wobei jeder Datensatz (Je$_1$) die ersten (E$_{Ci}$(t$_1$)) und die zweiten (E$_{Dj}$(t$_1$)) Daten, die dem Zeitintervall (t$_1$) zugeordnet sind, enthält,

**dadurch gekennzeichnet, dass** das Bestimmungssystem (12) außerdem Folgendes umfasst:

- ein Modul (44) zum Berechnen eines ersten Auswahlkriteriums (C1$_1$) für eden Datensatz (Je$_1$), wobei das erste Auswahlkriterium (C1$_1$) ein Kriterium ist, das aus einem globalen Anteil von Verlusten an elektrischer Energie zwischen dem einen oder den mehreren Abgängen (18$_j$) und den Verbrauchern (16$_i$) und einer Differenz des Verbrauchs an elektrischer Energie zwischen den verschiedenen Verbrauchern (16$_i$) gewählt ist,
- ein Modul (46) zum Auswählen als Funktion der ersten berechneten Auswahlkriterien (C1$_1$) einer ersten Gesamtheit (En$_1$) von Datensätzen (Je$_k$) unter den erzeugten Sätzen und
- ein Modul (48) zum Bestimmen anhand der ersten gewählten Gesamtheit (En$_1$) von Verbindungsparametern (a$_{ij}$), wobei die Parameter (a$_{ij}$) für jeden elektrischen Verbraucher (16$_i$) eine Kennung des Abgangs (18$_i$), mit dem er verbunden ist, enthalten.

## Claims

1. Method for determining the structure of an electricity distribution network (10), the method being implemented by a computer (24), wherein the distribution network comprises a supply station (14) having one or more electric power supply outputs (18$_j$) of several electrical loads (16$_i$), and comprising the following steps:

a) acquisition (100; 200; 300; 400) for each electrical load (16$_i$) of first data (E$_{Ci}$(t$_1$)) relating to the electric power consumed by the electrical load (16$_i$) during different time intervals (t$_1$) measured by means of a first power measurement sensor (20$_i$),
b) acquisition (100; 200; 300; 400) for each output (18$_j$) of second data (E$_{Dj}$(t$_1$)) relating to the electric power delivered by the output (18$_j$) during different time intervals (t$_1$) measured by means of a second power measurement sensor (20$_j$),
c) generation (102; 202; 302; 402) by means of a generation module (42) of several different data sets (Je$_1$), each associated with one of the different time intervals,

wherein each data set (Je$_1$) comprises first (E$_{C1}$(t$_1$)) and second (E$_{Dj}$(t$_1$)) data associated with said time interval (t$_1$), **characterised in that** the method additionally comprises the following steps:

d) calculation (104; 204; 304; 404) of a first selection criterion (C1$_1$) for each data set, wherein the first selection criterion (C1$_1$) is a criterion selected from a global rate of electric power losses between the output or outputs (18$_j$) and the loads (16$_i$) and a difference in electric power consumption between the different loads (16$_i$),
e) selection (106; 206; 306; 406) of a first unit (En$_1$) of data sets (Je$_k$) from the generated sets (Je$_l$) by means

of a selection unit (46) as a function of the first calculated selection criteria ($C1_1$),

f) determination (108; 208; 310; 408) from the selected first unit (En1) of connection parameters ($a_{ij}$), wherein for each electrical load ($16_i$) said parameters ($a_{ij}$) have an identifier of the output ($18_j$), to which it is connected.

2. Method according to claim 1, in which during the calculation step d) (204) a second selection criterion ($C2_1$) for each generated data set ($Je_1$) is calculated, wherein the second criterion ($C2_1$) is the other criterion selected from a global rate of electric power losses between the output or outputs ($18_j$) and the loads ($16_i$) and a difference in electric power consumption between the different loads ($16_i$),

and in which during the selection step e) (206) the first unit (En1) is selected as a function of the first ($C1_1$) and second ($C2_1$) calculated criteria.

3. Method according to claim 1, in which following the selection step e) the method comprises the following steps:

e1) calculation (307) of a second selection criterion ($C2_1$) for each data set ($Je_k$) of the first unit (En1), wherein the second criterion ($C2_1$) is the other criterion selected from a global rate of electric power losses between the output or outputs ($18_j$) and the loads ($16_i$) and a difference in electric power consumption between the different loads ($16_i$),

e2) selection (308) of a second unit ($En_2$) of data sets from the first unit (En1) as a function of the second selection criteria ($C2_1$),

wherein the determination of the connection parameters ($a_{ij}$) is then performed during the determination step f) (310) as a function of the second unit ($En_2$) selected from the first unit (En1).

4. Method according to one of the preceding claims, in which during the determination step f) (108; 208; 310; 408) the connection parameters ($a_{ij}$) are determined separately for each output ($18_j$) and independently of the second data ($E_{Dj}(t_1)$) relating to the electric power acquired for the other outputs ($18_j$).

5. Method according to one of the preceding claims, in which during the determination step f) (108; 208; 310; 408) a system of equations to be solved is determined from a postulate of electric power conservation for each output ($18_j$), according to which the power delivered by the output ($18_j$) is substantially equal to the sum of the power consumed by the electrical loads ($16_i$) connected to the output ($18_j$) and electric losses.

6. Method according to claim 5, in which during the determination step f) (108; 208; 310; 408) the system of equations is defined on the basis of the following equation:

$$E_{Dj}(t_k) = \sum_{i=1}^{n}\left(a_{ij}.E_{Ci}(t_k) + \partial 1_{jk} - \partial 2_{jk}\right)$$

where n is the number of electrical loads ($16_i$), j is an output ($18_j$) index varying from 1 to m, wherein m is the number of outputs ($18_j$), i is an electrical load index varying from 1 to n,

k is an index of a data set ($Je_k$) of the first unit ($En_1$) varying from 1 to w, wherein w is the number of data sets ($Je_k$) of the first unit ($En_1$), $t_k$ is the time interval associated with the data set ($Je_k$) of index k,

$a_{ij}$ is the connection parameter indicating whether the load ($16_i$) of index i is connected to the output ($18_j$) of index j,

$E_{Ci}(t_k)$ is the electric power consumed by the electrical load ($16_i$) of index i during the time interval $t_k$,

$E_{Di}(t_k)$ is the electric power consumed by the output ($18_j$) of index j during the time interval $t_k$, and

$\partial 1_{jk}$ and $\partial 2_{jk}$ are adjustment variables representing electric losses.

7. Method according to claim 6, in which the system of equations is written in a matrix form of the following type: A*z=B, where

$$
\begin{bmatrix} a_{11} \\ \vdots \\ a_{n1} \\ \vdots \\ a_{1m} \\ \vdots \\ a_{nm} \\ \partial 1_{11} \\ \vdots \\ \partial 1_{mw} \\ \partial 2_{11} \\ \vdots \\ \partial 2_{mw} \end{bmatrix}, \quad
B = \begin{bmatrix} E_{D1}(t_1) \\ \vdots \\ E_{D1}(t_w) \\ E_{D2}(t_1) \\ \vdots \\ E_{D2}(t_w) \\ E_{Dm}(t_1) \\ \vdots \\ E_{Dm}(t_k) \end{bmatrix} \text{ et }
A = \begin{bmatrix} U & 0 & \cdots & 0 \\ 0 & \ddots & \ddots & \vdots \\ \vdots & \ddots & \ddots & 0 \\ 0 & \cdots & 0 & U \end{bmatrix}
$$

[et = and]
with

$$
U = \begin{bmatrix} E_{C1}(t_1) & \cdots & E_{Cn}(t_1) \\ \vdots & \ddots & \vdots \\ E_{C1}(t_w) & \cdots & E_{Cn}(t_w) \end{bmatrix},
$$

and A having m*n columns and m*w lines.

8. Method according to claim 7, in which during the determination step an optimisation algorithm is used to solve the system of equations, wherein the optimisation algorithm verifies:

$$
\min_z f^T.z \quad \text{tel que } \begin{cases} A.z = B \\ l_z \le z \le u_z \end{cases}, \text{ où } f^T.z = \begin{bmatrix} \underbrace{0 \quad \cdots \quad 0}_{m*n} & \underbrace{1 \quad \cdots \quad 1}_{w*m} & \underbrace{1 \quad \cdots \quad 1}_{w*m} \end{bmatrix} \times z,
$$

[tel que = such as; où = where; et = and]

$$l_z = \begin{bmatrix} -\varepsilon \\ \vdots \\ -\varepsilon \\ 0 \\ \vdots \\ 0 \end{bmatrix} \text{ et } u_z = \begin{bmatrix} 1+\varepsilon \\ \vdots \\ 1+\varepsilon \\ +\infty \\ \vdots \\ +\infty \end{bmatrix}$$

with $\varepsilon$ ranging between 0 and 0.5.

**9.** Method according to one of the preceding claims, in which each output ($18_j$) comprises one or more electrical phase conductors and in which during the acquisition step b) the second data ($E_{Dj}(t_1)$) are acquired for each electrical phase conductor and relate to the electric power delivered by each electrical phase conductor, and during the determination step f) (108; 208; 310; 408) for each electrical load ($16_i$) the determined connection parameters ($a_{ij}$) have an identifier of the electrical phase conductor or conductors, to which it is connected.

**10.** Method according to one of the preceding claims, in which during the determination step f) (408) the method comprises the following steps:

f1) pseudo-random selection (408A) of a third unit ($En_3$) of data sets included in the first unit ($En_1$),
f2) determination (408G) of connection parameters ($a_{ij}$) from the third unit ($En_3$) selected from the first unit ($En_1$).

**11.** Method according to claim 10, in which following the selection step f1) (408A) and before the determination step f2) (408G) the method comprises the following steps:

f3) calculation (408B) of a parameter of repetition (R1),
f4) determination (408C) from the selected third unit ($En_3$) of intermediate connection indices ($b_{ij}$) having for each electrical load ($16_i$) an identifier of the output ($18_j$), to which it is connected,
f5) storage (408D) of the intermediate connection indices ($b_{ij}$), and
f6) comparison (408F) of the parameter of repetition with at least one predetermined repetition criterion (CR1),

and following the result of the comparison step f6) (408F), execution of a step selected from, on the one hand, repetition of the steps of selection f1), calculation f3), determination f4), storage f5) and comparison f6) and, on the other, the determination step f2) of connection parameters ($a_{ij}$) as a function of the stored intermediate connection indices ($b_{ij}$).

**12.** Method according to claim 11, in which the method comprises the following step:

f7) calculation (408E) for each load ($16_i$) and for each output ($18_j$) of an assignment number ($NA_{ij}$) relating to the number of times the stored intermediate connection indices ($b_{ij}$) indicate that the load ($16_i$) is connected to the output ($18_j$), and in which during the determination step f2) (408G) the connection parameters ($a_{ij}$) are determined from the calculated assignment numbers ($NA_{ij}$).

**13.** Computer program comprising software instructions, which when executed by a computer implement the method according to any one of the preceding claims.

**14.** System (12) for determining the structure of an electricity distribution network (10), wherein the distribution network (10) comprises a supply station having one or more electric power supply outputs ($18_j$) of several electrical loads ($16_i$), the system comprising:

• for each electrical load ($16_i$), a first measurement sensor ($20_i$) for first data ($E_{Ci}(t_1)$) relating to the electric power consumed by the electrical load ($16_i$) during different time intervals ($t_1$),

• for each output (18$_j$), a second measurement sensor (22$_j$) for second data (E$_{Dj}$(t$_1$)) relating to the electric power delivered by the output (18$_j$) during the different time intervals (t$_1$),
• a module (41) for acquiring first (E$_{Ci}$(t$_1$)) and second (E$_{Dj}$(t$_1$)) data,
• a module (42) for generating several different data sets (Je$_1$), each associated with one of the different time intervals (t$_1$),

wherein each data set (Je$_1$) comprises the first (E$_{Ci}$(t$_1$)) and second (E$_{Dj}$(t$_1$)) data associated with said time interval (t$_1$), **characterised in that** the determination system (12) additionally comprises:

• a module (44) for calculating a first selection criterion (C1$_1$) for each data set (Je$_1$), wherein the first selection criterion (C1$_1$) is a criterion selected from a global rate of electric power losses between the output or outputs (18$_j$) and the loads (16$_i$) and a difference in electric power consumption between the different loads (16$_i$),
• a module (46) for selecting a first unit (En$_1$) of data sets (Je$_k$) from the generated sets as a function of the first calculated selection criteria (C1$_1$),
• a module (48) for determining connection parameters (a$_{ij}$) from the selected first unit (En$_1$), wherein for each electrical load (16$_i$) said parameters (a$_{ij}$) have an identifier of the output (18$_j$), to which it is connected.

FIG.1

| Acquisition des données principales | 100 |
| Génération de jeux de données | 102 |
| Calcul du premier critère de sélection | 104 |
| Sélection du premier ensemble | 106 |
| Détermination des paramètres de raccordement | 108 |

## FIG.2

| Acquisition des données principales | 200 |
| Génération de jeux de données | 202 |
| Calcul du premier critère de sélection et du deuxième critère de sélection | 204 |
| Sélection du premier ensemble | 206 |
| Détermination des paramètres de raccordement | 208 |

## FIG.3

Acquisition des données principales 300

Génération des jeux de données 302

Calcul du premier critère de sélection 304

Sélection du premier ensemble 306

Calcul du deuxième critère de sélection 307

Sélection du deuxième ensemble 308

Détermination des paramètres de raccordement 310

FIG.4

```
┌─────────────────────────────────────────────┐
│  Acquisition des données principales          │──400
└─────────────────────────────────────────────┘
                    │
                    ▼
┌─────────────────────────────────────────────┐
│  Génération des jeux de données               │──402
└─────────────────────────────────────────────┘
                    │
                    ▼
┌─────────────────────────────────────────────┐
│  Calcul du premier critère de sélection       │──404
└─────────────────────────────────────────────┘
                    │
                    ▼
┌─────────────────────────────────────────────┐
│  Sélection du premier ensemble                │──406
└─────────────────────────────────────────────┘
                    │
                    ▼
┌─────────────────────────────────────────────┐
│  Sélection du troisième ensemble              │──408A
└─────────────────────────────────────────────┘
                    │
                    ▼
┌─────────────────────────────────────────────┐
│  Calcul du paramètre de répétion              │──408B
└─────────────────────────────────────────────┘
                    │
                    ▼
┌─────────────────────────────────────────────┐
│  Détermination des indices intermédiaires de  │──408C
│  raccordement                                 │
└─────────────────────────────────────────────┘
                    │
                    ▼
┌─────────────────────────────────────────────┐
│  Mémorisation des indices intermédiaires      │──408D
└─────────────────────────────────────────────┘
                    │
                    ▼
┌─────────────────────────────────────────────┐
│  Calcul du nombre d'affectation               │──408E
└─────────────────────────────────────────────┘
                    │
                    ▼
┌─────────────────────────────────────────────┐
│  Comparaison du paramètre de répétion au      │──408F
│  critère de répétition                        │
└─────────────────────────────────────────────┘
                    │
                    ▼
┌─────────────────────────────────────────────┐
│  Détermination des paramètres de raccordement │──408G
└─────────────────────────────────────────────┘
```

408

FIG.5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2458340 A2
- US 20110184567 A1
- WO 2009061291 A1
- WO 2012113936 A1